(19) Europäisches Patentamt
European Patent Office
Office européen des brevets

(11) **EP 3 139 630 A1**

(12) **EUROPEAN PATENT APPLICATION**

(43) Date of publication:
08.03.2017 Bulletin 2017/10

(51) Int Cl.:
*H04R 3/12* (2006.01)   *H04R 29/00* (2006.01)
*H04R 27/00* (2006.01)

(21) Application number: 16187211.4

(22) Date of filing: 05.09.2016

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(30) Priority: 04.09.2015 DK 201570575

(71) Applicant: Music Group IP Ltd.
Tortola (VG)

(72) Inventor: Arknaes-Pedersen, Lars
8260 Viby J. (DK)

(74) Representative: Patentgruppen A/S
Aaboulevarden 31, 4
8000 Aarhus C (DK)

(54) **METHOD FOR CONTROLLING POWER CONSUMPTION OF A LOUDSPEAKER SYSTEM**

(57) The invention relates to a loudspeaker system with power consumption control. The loudspeaker system comprises a powered audio bus, a bus driver connected to the powered audio bus where the bus driver feeds control information and audio information into the audio bus. The system further comprises loudspeaker nodes connected to the powered audio bus, where each of the nodes comprises a loudspeaker and an amplifier for driving the loudspeaker based on power from the audio bus, the control information and the audio information. The loudspeaker system further comprises a power consumption control arrangement arranged to reduce a power consumption of the loudspeaker nodes. The power consumption reduction may be obtained on basis of monitored parameters and may be performed for example by entering a standby mode, by reducing the bus voltage which powers the loudspeaker nodes, by reducing a switch frequency of the amplifiers and by other means.

Fig. 3

## Description

### Field of the invention

The present invention relates to loudspeaker systems, particularly to loudspeaker systems with active loudspeaker nodes distributed along an audio cable.

### Background of the invention

Loudspeaker systems with active loudspeaker nodes distributed along an audio cable may comprise a large number of power consuming active loudspeaker nodes, i.e. nodes comprising an amplifier powered via the cable and a loudspeaker driven by the amplifier.

Due to the large number of nodes, the total amount of power losses generated by the nodes may be significant and undesired.

Even nodes configured with power effective class D amplifiers may generate a significant total amount of power losses which may be unacceptable in view of today's requirements to energy savings.

Accordingly, power losses in such loudspeaker systems represent a problem. It is therefore an object of the invention to improve loudspeaker systems to achieve reductions in power losses.

### Summary of the invention

The inventors have realized that often in loudspeaker systems such as for example public address systems or other loudspeaker systems, a huge amount of energy is consumed in for example idling amplifiers when no audio is input to the system, irrelevant loudspeaker nodes with no listeners nearby to hear the sound of the energy they consume, powerful loudspeaker nodes that most of the time is used at only a fraction of their rated output power but nevertheless consumes more energy, etc. The inventors have therefore conceived the idea of controlling the power consumption in loudspeaker systems and have developed a method for controlling power consumption of a loudspeaker system, where the method comprises

- providing a powered audio bus;
- providing a bus driver connected to said powered audio bus, the bus driver being arranged to feed control information and audio information into the powered audio bus, the bus driver comprising a driver processing unit and a driver memory;
- providing a bus power supply connected to the powered audio bus, the bus power supply being arranged to feed power into the powered audio bus; and
- providing loudspeaker nodes connected to said powered audio bus, each of the loudspeaker nodes comprising

  o a node processing unit and a node memory;
  o a node receiver arranged to receive communication on said powered audio bus;
  o at least one loudspeaker and at least one amplifier arranged to drive said loudspeaker based on power from said powered audio bus and control information and audio information received from said powered audio bus by said node receiver; and
  o a power converter arranged to convert power from said powered audio bus to supply power to at least partly the node processing unit and the node receiver;

- using a subset of said loudspeaker nodes to produce sound based on said audio information and said control information;
- monitoring a power consumption impacting parameter;
- determining on the basis of the monitored power consumption impacting parameter when a criterion for power consumption control is fulfilled; and
- using a power consumption control arrangement on the basis of said criterion being fulfilled, thereby reducing power consumption of one or more of the loudspeaker nodes.

By the present invention is obtained an advantageous way of reducing the power consumption in loudspeaker systems that are built around a powered audio bus. The advantageous method thereby helps saving energy while at the same time increases lifetime of the electronics by less demanding operation.

According to embodiments of the invention, the loudspeaker system may for example be a public address system, i.e. a so-called PA system, background music or announcement system built into a hotel, shopping centre, restaurant or bar, sport centre, etc. Significant unnecessary and/or reducible power consumption mainly takes place in the loudspeaker nodes comprising power amplifiers, etc., so that is where substantial energy saving may be obtained. Hence, by reducing the power consumption of one or more of the loudspeaker nodes, energy is saved in the operation of the entire loudspeaker system as a whole.

The present invention may in various embodiments positively affect the reduction of power consumption both during operation and during idle, regardless of it being all loudspeaker nodes or only some loudspeaker nodes that operate or idles at a time.

A powered audio bus may according to embodiments of the invention comprise a wired connection from the bus driver to the loudspeaker nodes, preferably daisy-chained, which provides the loudspeaker nodes with power, audio information and control information altogether. The powered audio bus may in a preferred embodiment be established by a single twisted pair cable, and offer two-way communication. The bus driver is preferably arranged to control the loudspeaker nodes, including the audio they should render, and may in various embodiments be connected to other networks for further remote control, monitoring or delivery of audio.

The bus power supply is preferably integrated with or located by the bus driver, and provides in preferred embodiments the power needed by the loudspeaker nodes for both control, processing and amplification. The power converter in each loudspeaker node is preferably arranged to convert the power from the bus power supply, e.g. 48 VDC, to a voltage suitable to drive the low voltage electronics, e.g. related to small signal processing, DSP, communication and control tasks, in the loudspeaker node, e.g. 5 VDC. The power converter may in an embodiment also be arranged to supply the audio amplifier power stage, but in various preferred embodiments, to simplify the node electronics, the power stage of a switching audio amplifier operates directly with the bus voltage as its rail voltage.

A subset of the loudspeakers produces sound based on the audio information and control information, and thereby consumes power from the bus power supply. The subset may be any number of the connected loudspeaker nodes, including in periods none or all the loudspeaker nodes. In a preferred embodiment the loudspeaker nodes producing sound may produce the same sound or different sounds, for example enabled by providing two or more audio channels in the audio information of the powered audio bus.

In order to determine when the advantageous power consumption control of the invention may be relevant to invoke in a loudspeaker system, one or more power consumption impacting parameters are monitored. These parameters may be individual signals, e.g. an audio signal or voltage measurement, or they may be complex derivatives of several measurements or triggers, and they may be analyzed for an indication of whether or not power consumption may be impacted under the current operation conditions. To determine if power consumption control arrangements should or could be invoked, relevant criteria relating to the power consumption impacting parameters are provided. The criteria may be simple thresholds or true/false assessments, or they may be complex systems of statements which may be analyzed to determine if power consumption may be reduced.

Power consumption control arrangements comprise in various embodiments different procedures or units which may be invoked to reduce the power consumption of the loudspeaker nodes. For example, a power consumption control arrangement may comprise a unit arranged to enable standby and wake-up features of loudspeaker nodes, or to reduce output voltage of the power supply to reduce the bus power when high voltage is not required, etc.

According to an embodiment the loudspeaker system comprises multiple powered audio buses with integrated or network-connected bus drivers.

An embodiment comprises several powered audio buses working together to for example cover large buildings. In such an embodiment, there may not be a clear plan for the distribution of loudspeakers, which buses are represented in which rooms, etc., in particular if the system has been installed in several steps, perhaps over several years. When performing power consumption control for one powered audio bus, it may therefore be relevant to perform similar or complementing power consumption control of other powered audio buses in order to achieve a significant consumption reduction, or in order to not make differences noticeable to nearby listeners. For example, if two powered audio buses both have loudspeaker nodes in a same room, and one of the powered audio buses comprises a light sensor for being able to use a power consumption control arrangement of setting loudspeaker nodes to standby if the room is dark, this information may be relevant for the bus driver or loudspeaker nodes of the other powered audio bus. According to another example, several powered audio buses may share a common bus power supply, and hence the requirements of all loudspeaker nodes of all the powered audio buses should be taking into account when considering a power consumption control arrangement of reducing the bus voltage generated by the bus power supply. In yet another example, a power consumption control arrangement involving changing the audio processing to make the audio less energy requiring to produce as sound, may be invoked for loudspeaker nodes on one bus, and then it may relevant to invoke the same changes for other powered audio buses to have their loudspeaker nodes sound likewise, or oppositely, to have their loudspeaker nodes acoustically mask the shortcomings of the power-saving loudspeaker nodes.

The bus drivers of several powered audio buses may in various embodiments be integrated in one or a few devices, for example one bus driver device driving 4 or 16 powered audio buses. Several bus drivers may be connected in any network topology to communicate power consumption control-related information. The power consumption control may be controlled by a central controlled, which may comprise an integrated bus driver or several bus drivers each driving a number of powered audio buses, which together may be considered a central controller, or the central controller may be a separate central controller wired or wirelessly connected to the bus drivers.

According to an embodiment the loudspeaker nodes comprises a node transmitter arranged to transmit communication on said powered audio bus.

In various embodiments it may be beneficial to have the loudspeaker nodes perform some of the monitoring a power consumption parameter, or the determining when a criterion for power consumption control is fulfilled, and then transmit this information to the bus driver. By being able to transmit, the loudspeaker nodes may also be enabled to provide information on request from the bus driver, e.g. regarding their availability or capability for a certain power consumption control arrangement.

According to an embodiment the amplifier is a switching amplifier.

A switching amplifier, also referred to as class-D amplifier, is a preferred embodiment as it is power efficient and highly controllable.

According to an embodiment the power consumption control arrangement is arranged to set a loudspeaker node to a standby mode.

According to an embodiment, a standby mode of a loudspeaker node is any mode wherein some or all of the functions and subcomponents of a loudspeaker node are switched off and thereby reducing the node's power consumption compared to a fully functioning mode. Preferably the standby mode of a loudspeaker node comprises switching off at least the amplifier, thereby avoiding idle-time losses in the amplifier and loudspeaker, which may provide a significant reduction in idle power consumption in particular for class-D switch mode amplifiers and class-AB amplifiers. Preferably the standby mode of a loudspeaker node comprises keeping at least the node receiver on in order to recognize any instructions from the bus driver or other external component or sensor to wake up from the standby mode. In an embodiment a loudspeaker node may support multiple different standby modes characterized by different degrees of being shut down, for example different numbers of subcomponents switched off or different functions being disabled.

According to an embodiment the bus driver is arranged to control when to set a loudspeaker node to a standby mode.

The bus driver may advantageously be in control of the individual loudspeaker nodes entering or leaving standby modes.

According to an embodiment the loudspeaker node is arranged to control when to set itself into a standby mode.

In an embodiment the loudspeaker nodes may autonomously decide when to enter a standby mode. In an embodiment, the loudspeaker nodes can only decide when to enter a standby mode if so authorized by the bus driver. In a preferred embodiment, the standby mode comprises keeping the node receiver on in order to be able receive instructions for leaving standby mode from the bus driver or an external component, or in order to be able to for example detect when an audio signal for the respective loudspeaker node is present on the powered audio bus.

According to an embodiment the power consumption impacting parameter comprises said audio information.

Monitoring the audio information may provide an indication of when it is relevant to reduce power consumption in certain loudspeaker nodes. In particular if no audio signal is present on the powered audio bus, the bus driver may instruct the loudspeaker nodes to enter standby mode, or the individual loudspeaker nodes may decide to enter standby mode individually. Even if an audio signal is transmitted through the powered audio bus, it may not be intended for all loudspeakers nodes to render the audio signal, and the bus driver or the respective loudspeaker nodes may decide to enter standby mode.

According to an embodiment the power consumption impacting parameter comprises said control information.

Monitoring the control information may provide an indication of when it is relevant to reduce power consumption in certain loudspeaker nodes. In particular if the control information comprises instructions for a certain loudspeaker node to not process the current audio signal present on the powered audio bus, e.g. instructions such as the node being assigned to a different audio channel, the node being muted, the node being deactivated, etc., it may be advantageous to enter a standby mode to save power. The bus driver may analyse the control information and instruct the relevant loudspeaker nodes to enter standby mode, or the individual loudspeaker nodes may analyse the control information and decide when to enter standby mode individually.

According to an embodiment the criterion for power consumption control comprises a loudspeaker node not receiving audio for rendering and/or a loudspeaker node being muted.

According to an embodiment the power consumption impacting parameter comprises a human absence indication and the criterion for power consumption control comprises human absence within an acoustic proximity of a loudspeaker node.

In many loudspeaker systems not all loudspeaker nodes are subject for listening at all times. Depending on the particular loudspeaker system layout, there may be loudspeaker nodes in different rooms or other acoustically delimited environments, which are not all occupied by listeners all times, or all loudspeaker nodes of a particular powered audio bus may be in the same acoustic environment, which may however also become empty for example during certain periods of the day. In such scenarios it may be relevant to let any loudspeaker nodes that are not listened to, anyway, enter a standby mode to reduce their power consumption. In an embodiment, a proximity sensor or movement sensor, e.g. a passive infrared sensor (PIR-sensor), or noise sensor, e.g. a microphone, is connected to the loudspeaker system, for example directly to the bus driver or to one or more loudspeaker nodes, for determining when human absence is indicated and on that basis let respective loudspeaker nodes enter a standby mode. In an embodiment the human absence indicator may be derived from information about darkness, e.g. by receiving information from light switches or light sensors in a room. In an embodiment, the human absence indicator may be derived from a time schedule indicating that an environment will be vacated during certain periods.

In a preferred embodiment, loudspeaker nodes outside acoustic proximity of any listener may enter standby mode, i.e. when the sound produced by a loudspeaker node due to distance or obstacles such as walls may be considered insignificant to any listener. Thereby loudspeaker nodes in an empty room may enter standby mode as probably being insignificant for anyone outside the room, but in various embodiments also some of the loudspeaker nodes in a large environment, e.g. a large hall, lobby, airport terminal, long hallway, etc., may enter standby mode if they are sufficiently far from any listeners and other loudspeaker nodes are located closer to the listeners.

The human absence indication may in various embodiments be analysed by the bus driver or one or more individual loudspeaker nodes. In an embodiment, one or more loudspeaker nodes comprises a sensor or other input device to receive human absence information, e.g. light sensor, proximity sensor or noise sensor, and forwards the information raw or analysed to the bus driver, which may then make a decision about the relevance of entering a standby mode and instruct any relevant loudspeaker nodes, including the one equipped with the sensor, accordingly. In various embodiments, the human absence information may be received via a suitable interface of a loudspeaker node or the bus driver from an external device, e.g. from a lighting system, a surveillance system, etc.

According to an embodiment the loudspeaker nodes are arranged with a pop or click reduction arrangement.

Entering or leaving standby mode for a loudspeaker node comprising an amplifier and a loudspeaker may cause noise such as pop or click to sound in the environment, which is typically undesirable. It is therefore beneficial to provide the loudspeaker nodes with an arrangement, hardware and/or software implemented, for avoiding this effect. In various embodiments based on class-D amplifiers, the pop or click reduction arrangement may be implemented in the pulse modulator establishing the control signal for the power switches. In a preferred embodiment the pop or click reduction arrangement comprises arranging the pulse modulator, when turning on or starting after standby, to establish as the first pulse a deliberately narrower pulse than the regular pulses based on the audio signal. In a preferred embodiment the pop or click reduction arrangement comprises arranging the pulse modulator, when entering standby or being turned off, to first fade the audio out, and then establish a deliberately narrow pulse after the last of the regular pulses has occurred.

According to an embodiment the power consumption control arrangement is arranged to reduce a bus voltage generated by said bus power supply.

A relatively high voltage is typically desired on the powered audio bus, i.e. typically the highest voltage that may safely and practically within regulations be provided via the particular cabling used for the bus, for example 48 VDC, i.e. significantly more than what is typically required by the electronics of the loudspeaker nodes. The higher voltage is desirable as it causes less energy loss in cables and other resistances than transmission of the same amount of energy at a lower voltage but higher current. The relatively high voltage may also be desirable when considering the loudspeaker node amplifier design when the required sound energy is in the upper part of what the amplifier and loudspeaker is designed to produce, again because of energy conduction loss proportional to the conducted current.

For a class-D amplifier, the switch loss in the electronic switches, e.g. mosfets, typically relate to the applied rail voltage squared, so that a double voltage causes a quadruple energy loss in the switches. Hence, in this light it is advantageous to reduce the bus voltage of the powered audio bus to significantly reduce the switch loss and thereby the power consumption of the loudspeaker nodes.

At a lower bus voltage, besides the increased conduction loss, the amplifier and loudspeaker may also not be able to produce their rated sound pressure, and as mentioned above, the conduction loss may become significant and unacceptable at high currents, which is emphasized by lowering the voltage.

It is therefore a highly advantageous embodiment which may significantly reduce the power consumption of the loudspeaker nodes that is obtained by lowering the bus voltage when certain criteria are met. It should be noted, that the powered audio bus may comprise several, possibly different, loudspeaker nodes playing different audio at different settings. This makes it a non-trivial task to determine when the loudspeaker system as a whole may benefit from - and keep performing at - a reduced bus voltage.

According to an embodiment the power consumption impacting parameter comprises said audio information and said bus voltage.

According to an embodiment the criterion for power consumption control comprises the bus voltage being higher than required by said loudspeaker nodes.

In a preferred embodiment the bus voltage is reduced based on information about the audio actually playing by the loudspeaker nodes and the current bus voltage. As explained above, the reduction in power consumption by lowering the bus voltage is most effective when the loudspeaker nodes are producing sound at significantly less than their full capacity. Hence, in an embodiment the voltage reduction may be applied when it is determined that all of the loudspeaker nodes are currently rendering audio at for example half their capacity or less. This information may be determined from the audio information transmitted to the nodes. Again it should be noted, that in some embodiments the various loudspeaker nodes are set to apply different audio processing such as for example gain, compression, equalization, etc. to the audio signal they receive, which should be considered when determining the relevance and degree of bus voltage reduction to apply.

According to an embodiment the bus voltage is reduced to a bus voltage in the range of 10% to 99% of a nominal voltage of the powered audio bus.

Various embodiments may tolerate significant reductions as long as the bus voltage is sufficient for overcoming the voltage drop in the bus cables and for driving the electronics of the loudspeaker nodes. A powered audio bus with a nominal bus voltage of 48 VDC may in an embodiment for example safely be reduced to 25%, i.e. to 12 VDC, or even less, to still drive for example 16 loudspeaker nodes over 100 meters of cable as long as none of them are required to play loud. Such a voltage reduction causes the switch loss in the amplifiers to fall to as little as about 1/16 of the nominal switch loss, which is a tremendous achievement. In a preferred embodiment the bus voltage is reduced to below 80% of the nominal voltage of the powered audio bus.

According to an embodiment the amplifier is a switching amplifier arranged with a feedback loop to counteract said bus voltage reduction with respect to a sound pressure rendered by the loudspeaker nodes.

In an embodiment, the amplifier is a closed-loop class-D amplifier, which may thereby by itself compensate for the bus voltage reduction and together with the loudspeaker deliver the intended sound pressure level, provided that the audio signal received at the loudspeaker node comprises only low amplitude levels leaving room for the compensation within the dynamic range of the amplifier.

According to an embodiment the amplifier is a switching amplifier arranged to apply a gain (1/k) to the audio information or control information to counteract said bus voltage reduction with respect to a sound pressure rendered by the loudspeaker nodes.

In an embodiment, the amplifier is an open-loop class-D amplifier, and either the amplifier or the bus driver is arranged to apply a gain to the audio signal proportional to the reduction of bus voltage in order to be able to deliver the intended sound pressure from the loudspeaker nodes. The gain may in various embodiments be applied to the audio information by the bus driver or by the individual loudspeaker nodes, or be transmitted as a control information to the loudspeaker nodes.

In various embodiments, the combination of increased signal amplitude and lowered switch voltage may also advantageously increase the signal-to-noise ratio SNR of the amplifier to improve the rendered sound quality.

According to an embodiment the bus driver is arranged to determine a time and amount of bus voltage reduction.

It is preferable to let the bus driver determine when it is relevant to reduce the bus voltage and to what degree. The bus driver which typically receives or generates the audio and transmits the audio information to the loudspeakers, is the first by typically a few milliseconds, or more if a look-ahead delay is implemented, to be able to determine if a higher voltage will be required to render the current audio information. Moreover, the bus driver typically stores information about the loudspeaker nodes, and may therefore be able determine their different requirements and tolerances to lower bus voltages. Further, the bus driver in typical embodiment also generate the control information instructing the individual loudspeaker nodes about which audio channel they should render, at which gain or attenuation level, if individual equalization, compression or other audio processing is applied, etc. Hence, the bus driver may already have all the information required to determine a bus voltage that will suit all loudspeaker nodes currently active on the powered audio bus, and it is therefore preferred to let the bus driver determine a time and amount for applying this method of reducing power consumption.

According to an embodiment each loudspeaker node in a subset of the loudspeaker nodes regularly determines a minimum acceptable bus voltage and communicates this to the bus driver for the bus driver to determine a common acceptable bus voltage.

In an embodiment where the loudspeaker nodes make use of individual audio processing or parameters, it may be beneficial to let the loudspeaker nodes determine the bus voltage they require individually, and let the bus driver gather this information and together with information about the audio and general parameters determine when and to what degree voltage reduction could be applied.

According to an embodiment the power consumption control arrangement is arranged to couple subcomponents of one or more of said amplifiers in or out. The subcomponents may comprise different sets of switching power stages. The different sets of switching power stages may comprise field-effect-transistors FET with different drain-source on-resistance RDS(on).

In class-D amplifiers, power switches such as for example mosfets may be optimized for different application, for example optimized with a low RDS(on) for low conduction loss at high currents, or with a low gate-loss and low parasitic capacitance in general, for faster and less power consuming turning on. The latter typically comes at the cost of a higher RDS (on). The dominant challenge is the "Miller capacitor", Cgd, and the output capacitance, Cds. In an embodiment the amplifiers of the loudspeaker nodes are implemented with two or more sets of mosfets and insertion circuitry which the node processor may use to engage a most suitable set of mosfets for a certain task. A set of mosfets with low RDS(on) may for example be inserted in the power stage when the loudspeaker node is required to produce relatively high sound pressure, thereby reducing the conduction losses, whereas a set of mosfets with higher RDS(on) but correspondingly lower gate loss may be inserted in the power stage when the loudspeaker node is used for playing quietly, thereby reducing the switching losses. Altogether, this embodiment saves power in the loudspeaker nodes implementing this feature.

According to an embodiment the power consumption control arrangement is arranged to change an audio processing parameter.

Power consumption may be reduced by certain changes of the audio processing. Some changes may affect the quality of the sound produced by the loudspeaker system, whereas other audio processing changes may in some circumstances be used without noticeable effect on the sound.

According to an embodiment the audio processing parameter is an audio processing parameter of said bus driver.

The bus driver typically received or generates the audio that is transmitted to the loudspeaker nodes via the powered audio bus, and hence may apply audio processing common to all the loudspeaker nodes rendering that audio. Thereby changes in the common audio processing parameters which cause reduced power consumption, do so in all affected loudspeaker nodes. Examples of such parameter changes may be a simple reduction of audio level if acceptable, shaping or restriction of the audio frequency spectrum to a spectrum requiring less energy to reproduce, etc. The changes of audio processing parameters in the bus driver causing he transmitted audio to be less energy demanding to reproduce in the loudspeaker nodes, may be accompanied by relevant control information to ensure that the loudspeaker nodes handle the audio information in a less energy consumptive way.

According to an embodiment the audio processing parameter is an audio processing parameter of one or more of said loudspeaker nodes, e.g. audio level of one or more of said loudspeaker nodes or a switch frequency of one or more of said loudspeaker nodes.

The examples of changes in audio processing parameters mentioned above may also be performed in the loudspeaker nodes instead, either autonomously or as instructed by the bus driver via control information. Thereby the processing may be performed individually, for example to ensure high quality audio in some loudspeaker nodes, or to reduce quality and power consumption more in loudspeaker nodes at less significant locations. Further, individual changes may also be made in the loudspeaker nodes for example in node-specific audio processing, e.g. when the loudspeaker nodes are configured with individual equalization, room correction, sound pressure, etc., or handle individual audio channels. Individual audio processing changes may also be relevant to reduce power consumption based on local circumstances which may or may not be determined at the bus driver. A loudspeaker node may for example be equipped with a microphone to monitor the background noise and reduce the sound pressure and thereby the power consumption of that individual loudspeaker node when the background noise decreases and thereby makes it less demanding to make the loudspeaker be heard above the background noise. Another example for reducing the switch loss in a switching audio amplifier comprises controlling the switch frequency, for example in dependency of the amplitude and frequency spectrum of the audio to be amplified, as for example low frequency content and/or low amplitude levels allow for a lower switch frequency, which reduces the switch loss.

According to an embodiment the power consumption impacting parameter comprises said audio information or a background noise level.

In a related embodiment the criterion for power consumption control comprises a background noise level that has changed or that a difference between a sound pressure rendered by the loudspeaker nodes and a background noise level is not within a predefined tolerance of a target level above background noise level.

By adjusting the audio level and/or equalization on the basis of the background noise level, the loudspeaker nodes may reduce their power consumption at low background noise while even in many embodiments becoming more comfortable for the listeners, as for example unnecessarily loud announcements or background music is considered uncomfortable for most people. In an embodiment, the audio system enables a user or system to set a target level above background noise level for controlling sound pressure, instead of setting an absolute level. Thereby the audio system with the powered audio bus may control sound pressure at least partly relative to the background noise. A criterion for power consumption control may thereby comprise whether the sound pressure is maintained within a tolerance of a desired relative target level. For example, power consumption can be reduced if due to low background noise the produced sound pressure is higher than the desired target level above background noise level.

A second aspect of the invention relates to a loudspeaker system with power consumption control, the loudspeaker system comprising:

- a powered audio bus;
- a bus driver connected to said powered audio bus, the bus driver being arranged to feed control information and audio information into the powered audio bus, the bus driver comprising a driver processing unit and a driver memory;
- a bus power supply connected to the powered audio bus, the bus power supply being arranged to feed power into the powered audio bus; and
- loudspeaker nodes connected to said powered audio bus, each of the loudspeaker nodes comprising

    o a node processing unit and a node memory;
    o a node receiver arranged to receive communication on said powered audio bus;
    o at least one loudspeaker and at least one amplifier arranged to drive said loudspeaker based on power from said powered audio bus and control information and audio information received from said powered audio bus by said node receiver; and
    o a power converter arranged to convert power from said powered audio bus to supply power to at least partly the node processing unit and the node receiver;

- a monitoring unit arranged to monitor a power consumption impacting parameter;
- a testing unit arranged to determine when a criterion for power consumption control is fulfilled on the basis of the power consumption impacting parameter; and
- a power consumption control arrangement arranged to reduce a power consumption of one or more of the loudspeaker nodes on the basis of said criterion being fulfilled.

According to an embodiment the loudspeaker system of the second aspect is arranged to carry out the method of controlling power consumption of a loudspeaker system according to any of the embodiments.

The drawings

The invention will in the following be described with reference to the drawings where

| | |
|---|---|
| Figure 1 | illustrates an audio system of an embodiment of the invention, |
| Figure 2 | illustrates a bus driver of an embodiment of the invention, |
| Figure 3 | illustrates a node of an embodiment of the invention, |
| Figures 4 - 6 | illustrates a bus driver connected to a node in different network topologies of various embodiments of the invention, |
| Figures 7 and 8 | illustrate impedance balancing in an extended daisy chain network of an embodiment of the invention, |
| Figure 9 | illustrates different audio system layouts and subset of nodes of an embodiment of the invention, |
| Figure 10 | illustrates a loudspeaker system configured for achieving power loss reductions according to an embodiment of the invention, |
| Figure 11 | illustrates an open loop amplifier of an embodiment of the invention, |
| Figure 12 | illustrates different audio signals and sound pressure levels determined therefrom, |
| Figure 13 | illustrates an amplifier with different power stages of an embodiment of the invention, |
| Figure 14 | illustrates a diagram of a typical single supply power stage of an embodiment of the invention, and |
| Figure 15 | illustrates a diagram explaining the effect of delaying the audio signal in an embodiment of the invention. |

**Detailed description**

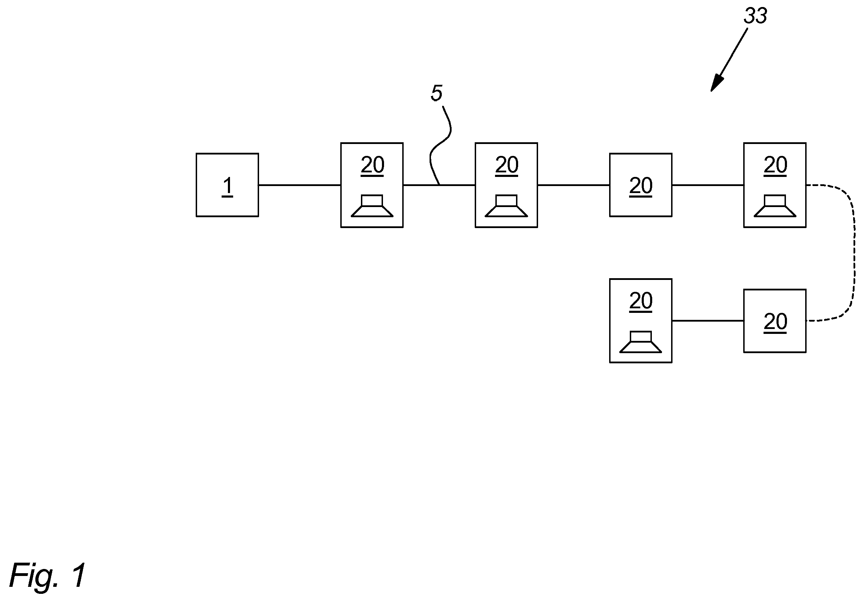

Figure 1 illustrates an audio system 33 according to an embodiment of the invention. The audio system 33 comprises a powered audio bus 5. A bus driver 1 provides control data, audio and preferably power to the powered audio bus 5. A number of nodes 20 are daisy-chained to the powered audio bus. Preferably at least a number of the nodes 20 comprises loudspeakers, for example a built-in active loudspeaker, an output stage with a loudspeaker output for connecting an external passive loudspeaker, or a line-out or equivalent for connecting an external active loudspeaker.

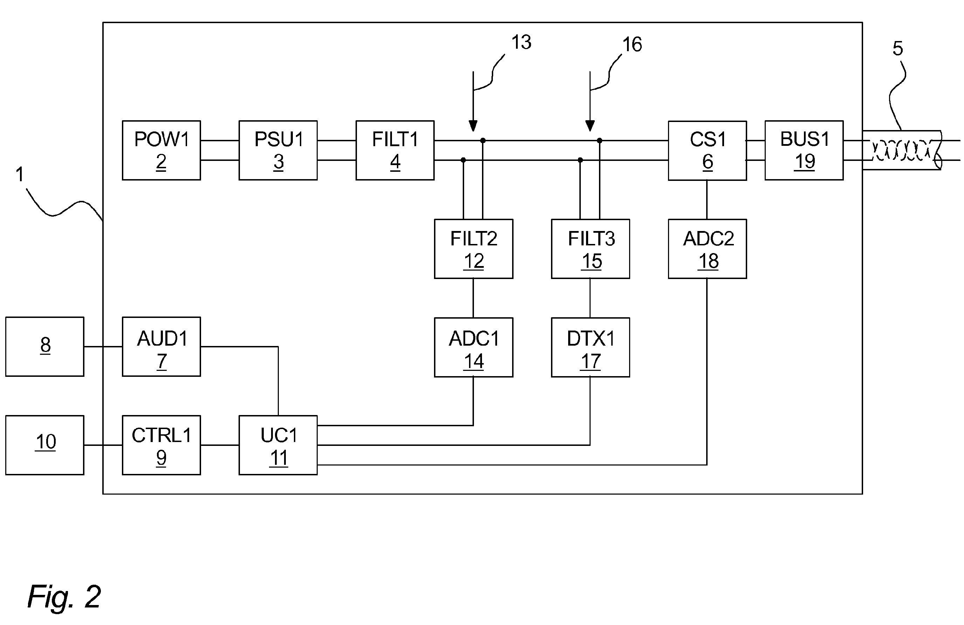

Figure 2 illustrates a bus driver 1 of the audio system 33 in more detail according to an embodiment of the invention. The bus driver 1 is preferably supplied with power from a driver power supply 2. This power supply may e.g. be connected to 110/230VAC mains, or comprise a DC source or any other electrical power source. Further, the bus driver 1 preferably comprises a driver power converter 3 which converts the incoming power to a DC voltage that supplies nodes 20 of the audio system 33.

Together the driver power supply 2 and the driver power converter 3 supply all electronics of the bus driver 1 and nodes 20 with suitable working voltages and may be referred to as bus power supply. The components of the bus power supply may be implemented in the bus driver 1 or may be external to the bus driver 1 and coupled directly to the powered audio bus 5.

The DC voltage is preferably below 50V and preferably between 40V and 50V. Preferably 48V is provided to the nodes 20 via the powered audio bus 5. The DC voltage should be balanced between low losses in the powered audio bus 5 (high DC voltage limits power loss) and secure or non-hazardous data transmission (low DC voltage facilitates avoiding conduits and compliance with safety requirements). Hence communication between the bus driver 1 and the nodes 20 therefore both comprise a supply voltage powering the nodes 20 and an audio signal for broadcasting via the nodes 20.

It should be mentioned that the capacity of the power supply 2 may vary from e.g. around 50W to over 1000W depending on the size and requirements to the audio system 33. Further, if considered necessary, an external (to the bus driver 1) power supply also referred to as injection power supply may be connected to the powered audio bus 5. The power is used at the nodes 20 for supplying local amplifiers, data processors, etc.

Power injectors for supplying additional power to the powered audio bus may preferably also be implemented as nodes and receive control data from the bus driver, for example in preferred embodiments to be shut off or disconnected during a node enumeration process to not disturb current measurements. The power injectors may for example use principles from the power over Ethernet (PoE) technology to inject power. Power injectors may provide power from mains, a battery or the like.

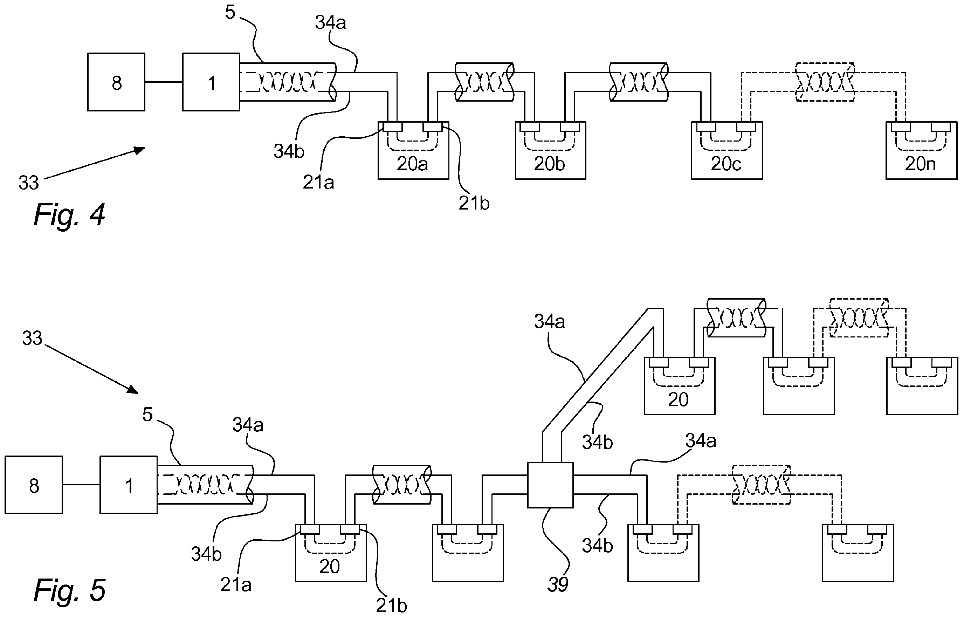

Preferably the bus driver 1 further comprises a first driver filter 4, which decouples the driver power supply 2 from the powered audio bus 5 (the preferably two conductors hereof denoted 34a, 34b of figure 4-6) with regards to alternating current. The first driver filter 4 may be implemented using power inductors, preferably with an inductance above 10uH for all operating currents.

Preferably the bus driver 1 further comprises a driver current sensor 6. This current sensor 6 is optional and if implemented, the current sensor 6 facilitates measurement of the current consumption on the powered audio bus 5 downstream from the bus driver 1. In addition, the driver current sensor 6 may act as a powered audio bus voltage monitor.

Preferably the bus driver 1 further comprises a driver audio interface 7, which acts as interface towards audio signal(s) between the bus driver 1 and an external audio source 8. Audio in this context may be analog (balanced or unbalanced electrical signal) or digital audio sent from the audio source 8 via WiFi, Bluetooth, Ethernet, USB, SPDIF, AES/EBU, ADAT, TOSLINK or through any other suitable digital protocol. Hence when referring to audio throughout this document a reference is made to a data signal which may comprise other information beside audio such as simple data, video, etc. to be exchanged between the bus driver 1 and the nodes 20.

Preferably the bus driver 1 further comprises a driver interface unit 9, which acts as interface towards control/information/status signal(s) between the bus driver 1 and external controller(s) 10. These signals may be sent through WiFi, Bluetooth, Ethernet, USB, RS232, RS485, or through any other suitable mechanism.

The bus driver 1 may include an internal audio source (not illustrated) or be connected to an external audio source 8 as described above. An external audio source 8 may be located as part of a LAN (LAN: Local Area Network) or the internet. It may be accessed remotely from the bus driver 1 e.g. via a wireless / wired LAN or the internet. The audio source 8 could be any audio player such as a portable device such as a tablet, smartphone, laptop etc. or it could be part of a larger setup for audio production and / or audio distribution such as a stationary media player, computer, data storage, radio, matrix unit, audio power amplifiers or the like. The audio source 8 could also be a "music player" inside the driver, like e.g. a radio receiver or a streaming media receiver, which receives digital audio from the internet.

The type of audio source 8 could be any source relevant for the application where the audio system 33 is in use and is therefore not important to the present invention. The present invention focus on the distribution of the audio signal and not on the source or type of the particular audio signal. Therefore, the driver audio interface 7 is not specified further in that different audio source 8 (if not part of the bus driver 1) could be connected to the bus driver 1 by various types of optical, wired or wireless audio and video connectors such as e.g. different types and sizes of jacks, plugs, connectors, screw / screw-less wire connections or the like, and the audio signals could be of various relevant analog or digital audio formats, encodings, compressions, container formats, etc.

The driver audio interface 7 and the driver interface unit 9 are preferably also used as interface to other audio systems, bus drivers 1, internet etc. In this way the audio broadcasted by the nodes 20 connected to the bus driver 1 can be coordinated with other bus drivers 1 of the same or other audio systems 33. It is thereby also possible to connect the audio system 33 to other systems such as home automation systems and provide information gathered from the nodes 20 or from the bus driver 1 to such system or retrieve information from such systems for use in the audio system 33.

The internet connection for the bus driver 1 also facilitates remote control and monitoring of the audio system 33 as such and of the individual elements hereof such as the nodes 20. This means that the health of a node 20 can be remotely monitored, faults can be located which facilitates faster maintenance or replacement, data from several audio systems 33 can be logged and used for statistics and future improvements, etc.

It should be mentioned that preferably, the audio source 8 is possible to reach from a not illustrated control interface. Such control interface may be used for selecting the particular audio from the audio source 8 to be broadcasted via the nodes 20, the quality, sound level, audio channel, etc. An example of a control interface could be an app installed on a mobile device such as a tablet or smartphone, or it could for example be implemented in the bus driver 1 or external audio source 8.

The fact that the audio system 33 facilitates remote or automatically enabled individual level control of the loudspeaker 32 of the nodes 20 has several advantages.

First this enables that a given sound profile in a single zone of nodes 20 can be changed dynamically without the need for mechanically adjusting e.g. a rotary switch on each individual node 20 or loudspeaker 32. This enables that a first node of a zone has a first sound level and a second node has another higher or lower sound level, hence, the sound level of the node at the bar or the restaurant is higher than the sound level of the node at the toilet, even though the nodes are of the same zone playing the same music.

This will be an advantage in zones where playback level requirements change over a daily rhythm, like in bars and restaurants. A second feature with this ability is that mix-minus can be implemented. Mix-minus is a technique where the audio level in the proximity of a person speaking in a microphone, is reduced so that the person does not hear his/her own voice at an amplified level. This feature increases the "naturalness" when using microphones. When several microphones exist within a single zone (e.g. in a conference room), it is required that the individual loudspeaker 32 can reduce its sound level as a function of which microphone is activated.

In addition, status information of the node 20 may also be measured and transmitted to the bus driver 1. Status information could e.g. be temperature, power consumption, loudspeaker impedance, etc.

Preferably the bus driver 1 further comprises a driver processing unit 11 which may be considered the main data processor of the bus driver 1 and as such of the entire audio system. The driver processing unit 11 gathers data and control/information signals and makes decisions about signal routing, nodes 20 operation etc. Hence the purpose of coordinating and controlling signals and data processing of the bus driver 1 is controlled by the driver processing unit 11. This may include defining quality of the audio signal, framing the manipulation made by the data processors, determining when and which audio signal should be transmitted from the bus driver 1, processing data received by the bus driver 1 and taking appropriate actions, calibration and set-up of nodes 20, etc.

The bus driver preferably facilitates two communication channels between the bus driver 1 and the nodes 20, but may in various embodiments only facilitate one, or more than two. An advantage of facilitating two communication channels may be to ensure some degree of communication even when circumstances make one of the communication channels unusable. Therefore the two communication channels are preferably designed according to quite different technologies with different shortcomings and advantages. In an embodiment, a first communication channel may for example allow for robust communication with a simple encoding at relatively low frequencies, but inherently slow, whereas a second communication channel may for example allow for high-frequency, high-data-bandwidth advanced communication, but relatively sensitive to any irregularities.

For the above-mentioned first communication channel, the bus driver 1 may for example comprise a second driver filter 12 and a first driver analog-to-digital converter 14. The second driver filter 12 facilitates attenuation and filtering of signals and noise received via the bus 5 which does not belong to the first communication channel, and it preferably decouples the DC power of the bus from the processing of the first communication channel by means of for example capacitors.

In a preferred embodiment, the first communication channel signal passing through the second driver filter 12 from the nodes 20 is an FSK (FSK: Frequency-Shift Keying) signal with a relatively low carrier frequency, in particular preferably well below the frequency contents of the second communication channel which preferably works at frequencies far above the human audible frequency range. An example of a suitable FSK modulation scheme for this application may be a binary FSK modulation using the frequencies 8kHz and 12kHz, where the second driver filter 12 may be a band-pass filter allowing signal to pass in that frequency region. The typical attainable bit-rate using such a mechanism for communicating on a bus 5 is in the range of a few kbit/sec. The method for communication is mainly determined by the desired amount of the information to be sent and the bandwidth of the powered audio bus 5, hardware at the node 20 / bus driver 1 facilitating data transmission (hardware here is any kind of data processor) and would in most cases be slow compared to the audio signal transmitted from the bus driver 1 to the nodes 20.

The first driver analog-to-digital converter 14 facilitates translation of the analog modulated communication signal (carrying digital data) of the first communication channel from the nodes 20 of the powered audio bus 5 to a digital (quantized in both amplitude and time) representation. In some cases, it would be advantageous to establish two-way-communication through this first communication channel 13. In case of such bilateral communication between bus driver 1 and nodes 20, the first driver analog-to-digital converter 14 may also comprise a digital-to-analog converter that translate a digital signal from the driver processing unit 11 into a time/amplitude continuous representation and pass that signal through the second driver filter 12. In the latter case a function in the digital-to-analog converter allows the digital-to-analog converter to adopt a hi-z mode when the first driver analog-to-digital converter 14 is receiving information from one or more nodes 20 on the powered audio bus 5. Preferably the driver processing unit 11 is arranged to process the, for example, FSK signal received through the first communication channel, and/or to generate, e.g., FSK signals for transmitting to the nodes 20 via the first communication channel.

For the above-mentioned second communication channel, the bus driver 1 may for example comprise a third driver filter 15 and a driver digital transmitter 17. The primary function of the third driver filter 15 is to decouple the DC power of the bus from the processing units of the second communication channel by means of for example capacitors, but it may also facilitate attenuation and filtering of signals and noise on the bus 5 which does not belong to the second communication channel.

At least the DC component from the powered audio bus 5 should be attenuated and preferably removed entirely. In a preferred embodiment, the second communication channel signal passing through third driver filter 15 may be a binary data signal holding audio related data and (optional) control data from the driver processing unit 11 to a node 20. One such binary data stream may comply with the AES3 (also known as AES/EBU) protocol having a typical rate at 44.1 kHz or 48kHz, holding two 24 bit channels. Other rates and/or protocols may also be used, however, the AES3 protocol has proven its worth over the last couple of decades as being a very robust audio transport protocol. As a part of this standardized protocol are "user data" and "channel status" bits. For this application, these may be used as means for controlling nodes 20.

Preferably as part of the second communication channel, the bus driver 1 further comprises a driver digital transmitter 17 facilitating conversion of a digital data stream from the driver processing unit 11 to a differential electrical signal, which may be passed through the third driver filter 15 to the powered audio bus 5. In a preferred implementation, the electrical signal complies with the RS-422 or the RS-485, which are robust standardized protocols for transporting digital data over long distances and in noisy environments. These standards have been the preferred choice in many industrial automation systems for several decades. Optionally, the driver digital transmitter 17 also comprises a digital receiver (not illustrated), such that bi-directional data streaming (half duplex) can be obtained between the driver 1 and the nodes 20. When receiving data, the driver digital transmitter 17 adopts a hi-z state which is typically a built in feature in most RS-485 transceiver integrated circuits.

Such digital receiver may be connected in parallel with the driver transmitter 17 and is preferably AC coupled to the powered audio bus 5.

When the audio signal from the audio source 8 has been processed by the bus driver 1 to comply with requirements e.g. to the quality of the signal, this signal is transmitted to the network of nodes 20 via the powered audio bus 5. The choice of digital audio transport is advantageous in that it is free for disturbances like cross-talk issues and hum (50/60Hz) artifacts and facilitates a plurality of parallel bi-directional information on the transmission conductors 34a, 34b of the powered audio bus 5 between bus driver 1 and nodes 20 such as a plurality of simultaneous audio channels along with communication of control data.

The audio / data transmission (simply referred to as audio transmission or data transmission) is preferably of a type facilitating data transmission effectively over long distances (e.g. up to a few hundred meters) and in electrically noisy environments as well as facilitating connection of multiple nodes 20 to the powered audio bus 5. Data transmission can be done in a very robust way by transmitting signals differential i.e. with information hidden in the difference between two conductors.

In a preferred embodiment, the audio transmission is complying with the TIA-485 standard (formerly known as RS-485 standard), an electrical digital layer which is very robust and reliable, but other standards could also be used. Hence the digitally encoded audio information is preferably superimposed on a DC supply voltage and communicated over the powered audio bus 5. The nodes 20 then comprise an audio decoder / node processing unit 23 that reconstructs the audio signal into a format suitable for input to the node power amplifier 31 (also referred to simply as node amplifier) or directly for input to the loudspeaker 32 which then produces the final audible speech, music, tones, etc.

In an embodiment, the bus driver 1 further comprises a second driver analog-to-digital converter 18 that allows the driver processing unit 11 to read current and voltage on the powered audio bus 5. This information can be used to detect powered audio bus fail and to help in automatically establishing a map over the bus network e.g. information of nodes 20 located on the powered audio bus 5.

The bus driver 1 may be connected at least to a main power supply or battery, analog audio (balanced or unbalanced), digital audio (electrical or optical) SPDIF, TOSlink, AES/EBU, ADAT, etc., network such as Ethernet, internet, RS232, CAN, etc., WiFi, Bluetooth, etc. Further, it should be mentioned that the bus driver 1 may have a user interface with buttons, (touch) display, LEDs, etc.

Preferably the bus driver 1 further comprises a driver-bus interface 19 facilitating the connection between the bus driver 1 and the powered audio bus 5 with its nodes 20. This connection may comprise EMI (EMI: Electro-Magnetic Interference) components that reduce electromagnetic interference from/to the bus driver 1. Such components may be capacitors, resistors, inductors, transient absorbing devices, and any other parts that improve the compatibility to/from the surroundings. The driver-bus interface 19 may also comprise a physical connector, which preferably is a so-called Phoenix connector, i.e. the typical loudspeaker connector used for professional fixed installations.

As mentioned, the bus driver 1 includes one or more data processors including controller units, analog-to-digital and digital-to-analog converters, filters, transmitters and receivers, interfaces etc. Hence when the audio / data signal (simply referred to as audio signal or data signal) is an analog signal, it is converted to a digital representation of the analog signal in a desired quality. Likewise if the audio signal is a digital signal, it is converted to an analog representation hereof in a desired quality. To obtain a desired quality of the audio signal, the data processors may perform mathematical manipulation of the audio signal such as filtering, compressing / decompressing, etc. the audio signal.

According to an embodiment of the invention, the bus driver 1 facilitates both transmitting and receiving of audio / digital signals to and from the nodes 20. Hence in situations where the nodes 20 are intelligent in the sense of being able to communicate to the bus driver 1 either based on own motion or as a reply to a query from the bus driver 1, the data processors may receive and process such communication. This processing may include converting such bidirectional communication between bus driver 1 and node 20 from a digital signal to an analog signal or vice versa. Further, extraction of information sent from the nodes 20 may also be necessary and be performed by one of the above mentioned data processors.

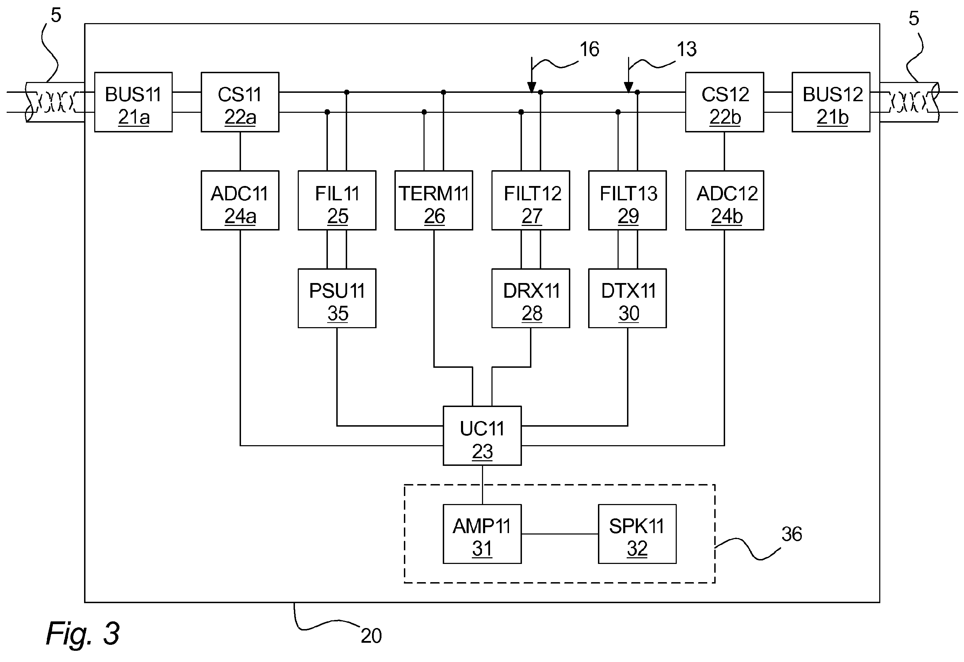

Figure 3 illustrates a preferred embodiment of the node 20 according to the invention. Preferably the node 20 comprises two node-bus interfaces 21 (21a first node-bus interface, 21b second node-bus interface) facilitating the connection of the node 20 to the powered audio bus 5. This connection may comprise EMI components that reduces electromagnetic interference from/to the bus driver 1. Such components may be capacitors, resistors, inductors, transient absorbing devices, and any other parts that improve the compatibility to/from the surroundings. The node-bus interfaces 21 may also comprise a physical connector, preferably a so-called Phoenix connector.

To ease the installation process and to minimize the risk of errors made during installation, the person mounting the bus driver 1 and nodes 20 to the powered audio bus 5 may freely connect either first node-bus interface 21a or second node-bus interface 21b to the upstream end of the powered audio bus 5 cable, meaning that the signal flow in the node 20 (from first to second node-bus interface) may be in either leftwards or rightwards direction. Further, the user is allowed to connect the preferably two conductors of the powered audio bus 5 cable to any of the terminals found in the node-bus interface 21 a, 21b, meaning that the polarity of the part of the powered audio bus inside the node 20 (conductors between first and second node current sensor 22a, 22b) may be either positive or negative. Again, this is advantageous in that it helps to ease the installation process and to minimize errors made in that process.

Preferably the node 20 further comprises a first node current sensor 22a and a second current sensor 22b, which are arranged so that the nodes 20 own current consumption can be distinguished from any downstream current consumption - regardless of both voltage polarity and signal (preferably a DC current) direction.

It should be mentioned that the first and second current sensors 22a, 22b may further comprise means for sensing the bus voltage level. Other suitable sensor structures may be used as long as the node processing unit 23 is able to obtain at least the downstream current consumption. The current sensors 22 may be implemented using Hall sensors, inductive based sensors, current to voltage conversion using a resistor having low resistance, or any other suitable mechanism.

Ideally, the current sensors 22 does not cause any signal changes from node input to output, such that signals at the node-bus interfaces 21 are identical, meaning that they are fully transparent in both directions.

Several circuits may establish a current estimate, which is able to estimate current regardless of its polarity and current flow direction, preferably the current sensors 22 are implemented as resistors referring to zero (ground potential). Having two (identical) current sense circuits and the knowledge of bus polarity allow the slave to choose to take the current information from the current sense circuit that is connected to the ground potential. Current is preferably sensed across two resistors. This makes the node able to distinguish between its own current consumption and the downstream consumption.

Accordingly, the current sensors 22 together with e.g. the node processing unit 23 and other not mentioned components may be referred to as a bus power monitoring unit.

Preferably the node 20 further comprises a first and second node analog-to-digital converter 24a, 24b that allow the node processing unit 23 to read current and voltage on the bus, sensed as described above.

Preferably the node 20 further comprises a first node filter 25 facilitating blocking of AC currents. The purpose of the first node filter 25 is to extract DC current for powering the node 20. This first node filter 25 may be implemented using inductors having a relatively large inductance, preferably above 100uH. This is because when looking at larger audio systems comprising several nodes 20, several of these first node filters 25 will be mounted in a parallel on the powered audio bus 5.

Preferably the node 20 further comprises a node power converter 35, also simply referred to as node power supply.

The DC supply voltage from the bus driver 1 is converted at the node 20 to a voltage level of e.g. between 1V and 12V for supplying one or more data processors and other power consuming components of the node 20.

To make sure that high frequency components of the digital audio signal of the powered audio bus 5 are not "short circuited", e.g. an inductor may be implemented between the powered audio bus 5 and the components of the node 20.

Preferably the node 20 further comprises a transmission line termination unit 26, that ideally inserts an impedance if the node is at one end of the powered audio bus 5 (preferably the farthest or the last node 20 in a series of nodes 20 on the powered audio bus 5) to eliminate transmission line reflections. The node may determine itself whether it is at the end of the powered audio bus, or, preferably, the bus driver instructs the appropriate node to insert its transmission line impedance. The transmission line termination unit 26 is controlled from the node processing unit 23, which can insert a transmission line termination impedance using a relay, transistor, MOSFET or by any other suitable means. In a preferred embodiment, the transmission line termination impedance is a resistor in series with a capacitor.

It should be mentioned that the powered audio bus 5 should be terminated in both ends. At the bus driver 1 end of the powered audio bus 5, the output impedance is known e.g. from the driver digital transmitter 17.

Preferably the node 20 further comprises a second node filter 27 that attenuates signals components not of interest for passing the digital audio and control streaming data. At least the DC component is attenuated or preferably entirely removed. Such AC coupling may be implemented using capacitors and resistors.

Preferably the node 20 further comprises a node receiver, preferably a node digital receiver 28 that receives the digital audio signal (preferably via the second communication channel 16) outputted from the controller digital transmitter 17 of the bus driver 1, and passes this signal on to the node processing unit 23. The node digital receiver 28 may also (optionally) include a digital transmitter and may be implemented using a RS-485 receiver/transceiver.

Preferably the node 20 further comprises a third node filter 29 for the first communication channel that attenuates signals components not of interest for passing the control/information/status data. In a preferred embodiment, the data is encoded using frequency shift keying FSK at a carrier frequency that do not disturb the digital streaming data sent through the second communication channel 16 - as described above. The third node filter 29 may be implemented inductors, capacitors and resistors.

Preferably the node 20 further comprises a node transmitter 30 facilitating outputting a modulated version of the status data sent from the node processing unit 23 to the bus driver 1. In a preferred embodiment, this may be done by using frequency shift keying FSK, in that FSK may be robust even though the farthest node 20 is not terminated yet. In this way the node 20 can be identified e.g. by means of an identifier send from the node 20 to the bus driver 1. The node transmitter 30 may be implemented by using simple buffers from the 74HC logic family (outputting squarewave signals) or by using a digital-to-analog converter. Output of the node transmitter 30 is ideally tri-stated when not sending data. Optionally the node transmitter 30 may be implemented in a bidirectional fashion, similar to the first controller analog-to-digital converter 14 of the bus driver 1.

Preferably the node 20 further comprises a node processing unit 23 acting as the main data processor of a given node 20. It receives (from the node digital receiver 28 or from any other audio sources, not illustrated), process, and outputs audio signal to a node amplifier 31 or any other audio output channels (not illustrated). Further, the node processing unit 23 receives control signals at least from either the node digital receiver 28 and/or from the node transmitter 30. These control signals are interpreted and suitable actions are carried out on basis of the control requests. The node processing unit 23 is also an important part of the "end-of-cable" identification process and the node enumeration process of the illustrated embodiment.

Preferably the node 20 further comprises a node power amplifier 31 that drives one or more loudspeakers 32. The node power amplifier 31 preferably receives audio from the node processing unit 23 (or from other sources) and may receive audio signals using an either analog and/or digital interface (not illustrated).

The node power amplifier 31 may both be of an analog (time-continuous) or a digital (time discrete) type having either an analog input signal or a digital input signal.

According to a preferred embodiment of the invention, the preferred node power amplifier 31 is a class-D amplifier. Due to the fact that the audio signal from the driver processing unit 11 preferably is a digital audio signal, the node power amplifier 31 is preferably a class D amplifier having a digital input, thus requiring no digital-to-analog converter.

With the distributed amplification at each individual node 20, where each loudspeaker has its own node power amplifier 31, the sound quality can be improved compared to the traditional 70VRMS/100VRMS systems. In the traditional systems, the audio power signal has to pass through an inherent transformer found as a part of the loudspeaker node 20. Such transformer causes core saturation effects for low frequency signals, meaning that a filter is always invoked that attenuates these signal components and thus attenuates the low end of the frequency spectrum. Getting rid of the transformer thus enhances the sound quality with a better and more "tight" bass reproduction.

Preferably the node 20 further comprises a loudspeaker 32 that comprises one or more passive loudspeakers. In a preferred embodiment of the invention, the loudspeaker(s) is (are) of the electrodynamic type, having an impedance in the range of 2-32 Ohm.

The node power amplifier 31 and loudspeaker 32 may form part of a utility unit 36 of the node 20. The utility unit 36 may also comprise a data processor, the purpose of which may be to convert and transmit data received from a transducer such as the loudspeaker 32 (making the loudspeaker 32 act as microphone) or other not illustrated transducers such as microphones, light sensors, smoke sensors, temperature sensors, proximity sensors or the like, or emitters or actuators, e.g. LEDs, displays, etc., or interface devices, e.g. buttons, Bluetooth transceiver, IR transceiver, connectors for wired external devices, etc. Example of use of such transducers could be a microphone, preferably connected to node processing unit 23, e.g. via an A/D-converter, which may be employed for any of the following or other uses: estimate ambient noise level or speech (e.g. to determine human presence), auto calibration, test of loudspeaker, determine location of other loudspeakers, sound level triggered burglar alarm, etc.

Such transducers could be standalone or integrated into the node 20 / bus driver 1, separate monitoring nodes connected to the powered audio bus 5, connected separately to the bus driver 1, etc. Such recorded information is transmitted (if necessary, after conversion from digital to analog or vice versa) by a suitable data processor to the bus driver 1 via the powered audio bus 5. Alternatively or in addition hereto, such information may be stored in a local memory (not illustrated).

As mentioned, the nodes 20 are preferably supplied with a DC voltage from the bus driver 1 via the powered audio bus 5 which preferably comprises at least two separate conductors 34a, 34b.

The size in terms of power consumption of a node 20 is mainly determined by the size of the loudspeaker 32 and examples of power consumption of the nodes 20 could be between 2W and 400W or higher, if needed, depending on purpose of use of the audio system 33, when operating at maximum power capability.

The fact that the nodes 20 comprise built-in data processing makes the nodes 20 intelligent thereby facilitating the creation of physical smaller nodes 20 with individual (possible remote) level control, audio source selection, etc.

As mentioned, these data processors facilitates, according to a preferred embodiment of the invention, digital signal processing, class-D modulation and facilitates receiving the digital signal transmitted via the standard or proprietary protocol as described above. In addition to the above described operations, these data processors may also facilitate operations from the following non-limiting list of operations which includes: equalizing, artificial reverberation, linear filtering, compensating the loudspeaker, limiting, compensating dynamic drop of DC voltage on the powered audio bus, registering and translation of sensor signals, frequency shift keying modulation, Class-D modulation to drive the loudspeaker, bass enhancement, speak and/or music discriminator which control equalizing speak and thereby making the speak easier to understand and/or making music sound better, etc.

It should be mentioned that some of these operations may also be facilitated by the data processors of the bus driver 1.

It should be mentioned that according to an embodiment of the invention, the bus driver 1 may at least partly be implemented as part of a node 20. Hence in this way, one single node 20 may comprise the bus driver 1 and thereby no standalone bus driver 1 may be necessary.

The illustrated bus driver 1 and nodes 20 are built from different components and it should be mentioned that the components and bus driver 1 and node 20 as such mentioned in relation to figures 1-3 may be combined in any suitable way to facilitate the desired audio system 33. Further, not mentioned components may also be needed such as a driver memory or node memory for storage of information retrieved during operation of the audio system 33 or preloaded with information relevant to operation of the audio system 33. Such memories could be of a minimum capacity such as a simple ROM only comprising an identifier such as a serial number of the node. However in most situations, the memories may be of a size capable of storing more data such as megabyte or gigabyte and of a type facilitating both reading from and writing to.

Further it should be mentioned that the fact that several data processors are mentioned should not be understood literally in that these may alternatively be implemented as one or more multifunctional data processors / units.

The audio system 33 of the present invention facilitates an intelligent audio signal distribution from bus driver 1 to individual nodes 20 and from nodes 20 to the bus driver 1 as will be described below.

Figure 4 illustrates an audio system 33 according to an embodiment of the invention comprising an audio source 8 connected to or part of a gateway also referred to as bus driver 1, transport media referred to as powered audio bus 5 or transmission line and a plurality of nodes 20. The powered audio bus 5 preferably comprises a first and a second conductor 34a, 34b.

To distribute power from an energy source internal or external to the bus driver 1 (audio power amplifier or power supply) to a passive or active node 20, the preferred choice for implementing the powered audio bus 5 is copper cables, since copper offers the best conductance. Aluminum cables could also be attractive, even though its resistivity is higher, as the total cost of cabling currently would be less than cobber cables and thereby it currently provides a better conductivity to weight ratio than copper. However, aluminum has a drawback when it comes to standard terminals, like common screw terminals, because metal oxidation will begin to act as an electrical insulator in a thin aluminum oxide layer. Further, the screw terminal requires a larger size to fit the larger wire dimension required to offer similar resistance as copper.

In relation to the distribution of an audio signal in either analog or digital form at least three options exist namely wireless using radio wave technology like WiFi, Bluetooth, ANR, ZigBee etc., optically using glass or plastic light-guides or electrically using conductive wires.

The wireless technology is at present not considered an option by professional audio integrators and consultants in that it is not considered robust enough. However for audio systems 33 with low requirements to robustness, wireless technology is an option as it most likely will be in the future for audio systems 33 having higher requirements to robustness as the wireless technology develops further. Another argument for not selecting wireless technology as the preferred technology is that wireless systems would require receiver/transmitter at the nodes which then would increase power consumption and thereby price of the audio system 33. Again, on the other hand, the benefits of the wireless system may compensate for these drawbacks in certain audio systems 33.

The optical data transfer technology has advantageous properties. First of all, the data bandwidth capabilities of an optical link are excellent. Optical fibers offer an extremely high data-rate for a given size of fiber and the signal quality loss, as a function of cable length, is low compared to electrical conductors. The downside however of optical fibers is the termination of the cable. When it has to be connected to a given device, the cable has to be cut and connected to the device through an optical receiver that translates light to an electrical signal. The cutting and mounting process is complicated, compared to a simple RJ45 plug or screw terminal connector. Electrical conductors are preferred for use as transmission conductors 34a, 34b for carrying the audio signal from the bus driver 1 to the nodes 20 and vice versa and both in relation to analog and digital audio signal transport, a distinction between single-ended or balanced signaling can be made.

In a single-ended approach, the electrical information is placed relative to a common ground potential. This approach is primarily used for short distances and is simple and requires only a single transmitter and a single receiver for a single channel audio stream (analog or digital). However, the topology has one main drawback which is a lack of common-mode rejection.

To overcome the flaws of the single-ended communication topology, balanced signaling is preferred. This technique uses two conductors per information stream. The basic idea is to send out the information as a differential signal that holds the information as a difference between the electrical voltages on two conductors. Typically, this requires two (identical) individual transmitters that output the utility signal with opposite phase. In the receiver end, the difference is found using a differential amplifier that have a high Common Mode Rejection Ratio, meaning that any signal component common for the two conductors are canceled out. This means (in contrast to the single-ended topology) that even though common voltage potentials on the transmitter device and sender devices bounce up and down, this is not causing any false differential signal seen by the receiver.

Beside the advantage in relation to rejection of common-mode when using balanced signaling, the conductor pair, especially when the two conductors are twisted, also has much better properties regarding potential interference from and to other electrical conductors. Such interference could e.g. origin from electromagnetic disturbances from external sources (other cables in cable trays etc.).

Therefore the powered audio bus 5 according to a preferred embodiment of the invention is one type of standard commercial audio cable with insulated twisted pair cobber conductors such as the "Belden 5300U" type of security and commercial audio cable. With this said other types of cables could also be used such as shield or unshielded multi-conductor Cat5 cables or other cables, shielded or unshielded twisted pair type.

Key feature in deciding type of cable is that the cable is capable of transmitting digital signals at a high bitrate and that it complies with EMC requirements. In addition, it is preferred if existing cable e.g. used in existing 70V/100V analog audio systems could be used. Surprisingly the "Belden 5300U" (and similar) type cable facilitates transmission of digital signal at high bitrate and because the conductors are twisted, the cable are complying with EMC requirements and are commonly used in existing 70V/100V systems.

In principle, using a two conductor shielded cable gives three conductors which may be needed in some embodiments.

It should be mentioned that according to a preferred embodiment of the invention, the powered audio bus 5 is connecting a plurality of nodes 20 to the bus driver 1, preferably in a daisy chain network. Though it could be indicated from the figures of the daisy chain structure that the nodes 20 are series connected, the nodes 20 are substantially parallel connected from an electric point of view.

As mentioned the nodes 20 of the audio system 33 are preferably connected in a daisy chain network by a two conductor type transmission media also referred to as powered audio bus 5. It is preferred that the powered audio bus comprise two conductors 34a, 34b mounted directly in loop terminals also referred to as node-bus interface 21 of the nodes 20 which is illustrated on figure 4. As illustrated on figure 4, one end of each of the first and second connectors 34a, 34b is connected to a driver-bus interface 19 of the bus driver 1 and the opposite end of the first and second connectors 34a, 34b is connected to the node-bus interface 21 of the node 20a. The node-bus interface 21 of the node 20b is chained via the first and second conductors 34a, 34b to the node-bus interface 21 of the node 20a and so on.

As mentioned above, the nodes 20 are developed in such way that installation i.e. mounting of the transmission conductors 34a, 34b cannot lead to failure nor by confusing the mounting of the conductors 34a, 34b, neither to a particular terminal nor by confusing which of the node-bus interfaces 21a, 21b these conductors 34a, 34b should be mounted at. Thereby it is ensured that the audio is always in phase in that polarity of the conductors can be ignored and mounting of nodes 20 in the audio system 33 therefore becomes very easy and can be done without special knowledge to audio systems in general.

Preferably the conductors 34a, 34b of the powered audio bus 5 are connected directly to the nodes 20. Thereby additional conductors from the node 20 to the powered audio bus 5 e.g. a junction box connecting the additional conductors to the powered audio bus 5 is avoided which is an advantage in that such additional conductors could make communication of information from node 20 to bus driver 1 difficult. An example of such communication could be automatic individual node identification (e.g. node identification is sent to the bus driver 1 e.g. upon a request from the bus driver 1) or location of a node 20 in the network.

An advantage of daisy chained nodes 20 connected as described in this document is, according to the invention, that multiple audio channels can exist within a single transmission line (either as multiple conductors or as multiple digital audio channels within a single conductor pair), thereby making the audio system 33 and the installation as such more flexible. Since a single cable (powered audio bus 5) can carry the audio signal for more than one single subset of nodes 20 or zone of nodes 20, the cabling layout can be simplified and thus labor cost can be reduced. In fact, existing audio systems having a transmission line comprising at least one conductor pair can be retrofitted or updated to an audio system of the present invention.

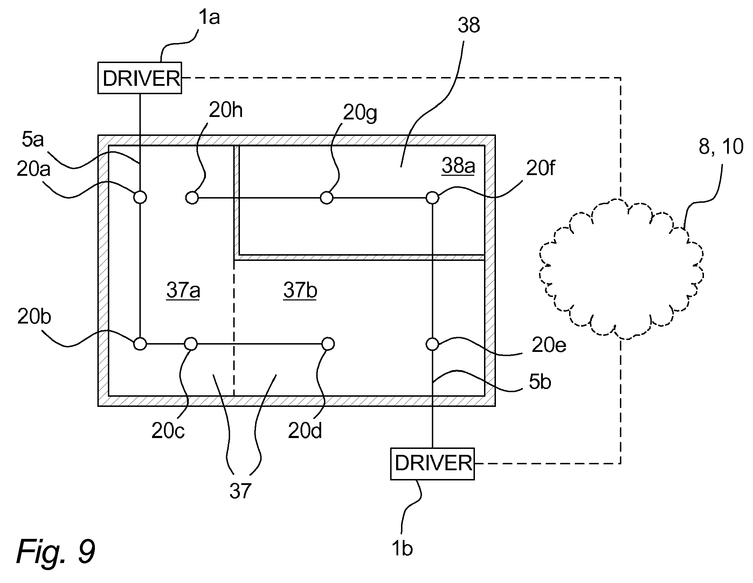

One single daisy chain of nodes 20 would potentially supply several different loudspeaker zones with individual audio channels as illustrated on figure 9 which illustrates a planar view of an audio system 33 according to the invention.

The audio system 33 of the present invention is very flexible in terms of number of audio channels, number of nodes 20 in a zone and in the daisy chain network and size or length of the powered audio bus 5 from the bus driver 1 to the last / farthest node 20 in the network.

The size of such daisy chain network could be determined by the number of audio channels and the quality of audio on these channels. According to an embodiment of the invention, a daisy chain network with two 48kHz audio channels would work fine even at a length of 100 meter of the powered audio bus 5 with sixteen 16 nodes 20 connected hereto.

With regard to the number of nodes 20 of the daisy chain, the limiting factor here is the degradation of transmission line quality and introduction of reflections each time a node 20 is added which introduces the risk of bit-errors.

Each parameter (nodes, quality, length, channels) are mutually influencing each other hence if e.g. only one channel is needed, the length / size of the daisy chain network can be increased. Another example could be if quality is required at 48kHz / 24 bit, then bandwidth may only allow two channels whereas the same bandwidth (48000*24*2 = 2.304 Mbit/sec) could be used to stream four 36kHz/16bit channels.

In general, it should be mentioned that it is preferred that the control of the nodes 20 i.e. distribution and broadcasting / producing of audio has higher priority than monitoring i.e. nodes 20 return information of the node 20 and its surroundings to the bus driver 1. The latter upstream status information may be sent at a few kbit/s, which enables that simple status information of a few bytes can be received from multiple nodes within a second by the bus driver 1.

In addition to the downstream audio stream and the upstream status, the downstream control signals i.e. queries, requests, status or user bits, etc. from the bus driver 1 to nodes 20 is also transmitted on the powered audio bus 5 e.g. at a speed of for example 96 kbit per second.

The audio system 33 preferably facilitates automated initialization i.e. upon request from the bus driver 1 each node 20 replies e.g. with type, serial number, etc.

As mentioned, the bi-directional data streaming enables end-node 20 monitoring. This enables a remote service functionality, where the entire audio system 33 including the nodes 20 and their loudspeakers 32 can be checked and precise error information is at hand before a service technician is at the location. This feature is also advantageous in the installation phase of the audio system 33, especially during installation of the daisy chain to verify the installation without the need for manually checking each individual node 20. When the bus driver 1 is connected to the internet, the remote services can be used from anywhere with connection to the internet.

The network layout illustrated on figures 4-6 is preferable a daisy chain topology, which resembles a coupling where the network bus driver 1 and network nodes 20 all sit electrically coupled in parallel or substantially in parallel. The node-bus interfaces 21a, 21b of the nodes 20 are virtually a short circuit, only having resistive loss from connectors and current sensors 22. Network examples can thus be illustrated as shown in figures 4-6 (connectors and current sensors not illustrated).

To minimize reflections in the cable constituting the powered audio bus 5, it is important to ensure that source impedance (bus driver output impedance), cable impedance and termination impedance (termination impedance is attached between bus conductors 34a, 34b in the last / farthest node 20 in a given branch or daisy chain) are identical or substantially identical. In a preferred embodiment of the invention, these three impedances (seen from a differential perspective in the range from 100kHz to 10MHz) are all in the range of 40 to 120 Ohm.

The network topology, however, is not bound to the pure daisy chain. Using Y-splitters 39 as illustrated in figure 5, the powered audio bus 5 may be divided into two (or even more) branches. To keep the impedance matching intact, it is important to insert a termination impedance in the end of both branches. It is furthermore required to add impedance matching means in the Y-splitters 39.

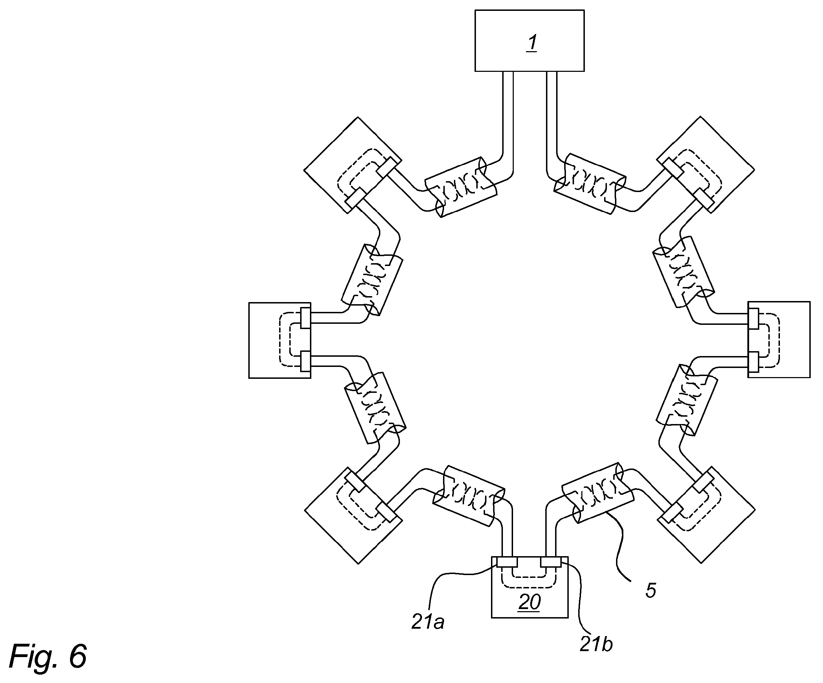

Figure 6 illustrates an example of a ring topology powered audio bus according to an embodiment of the invention. A powered audio bus 5 with several daisy-chained nodes 20 as described above are connected at each end to two individual audio bus ports of a bus driver 1. The bus driver is configured to handle the two ports as one powered audio bus of a ring topology, or detects this situation itself, e.g. by being able to receive its own control data of one port at the other port. Preferably, the bus driver makes one of the ports inactive, and may in various embodiments apply a transmission line impedance at the inactive port, or rely on the node nearest to the inactive port to be detected as farthest node and be instructed to apply its transmission line impedance as described above. An advantage of ring-topology embodiments is that in the case of cable break, disconnection of a node or other events that amputates a part of the powered audio bus from the bus driver, this situation may be detected by manual alarm input, by detecting impedance mismatch, low-quality communication, or by other automatic means, and upon concluding that a part of the bus is unreachable, the bus driver may activate the second port, perform node enumeration procedures on both ports, and thus proceed operation with two individual, powered audio buses. In other words, the ring topology enables a redundancy which is highly advantageous for critical audio systems, e.g. emergency or evacuation systems. The ring topology may also be implemented by various other embodiments, for example by providing an individual bus driver at each end of a powered audio bus, and either manually or automatically coordinate between the two bus drivers which one is active during normal operation, thereby still allowing the other bus driver to take over part of the powered audio bus in case of disruption. Thereby the bus driver function is also made redundant, and may advantageously be located in different physical locations to preserve one driver even in case of local fire, power loss, etc. A variation of the ring-topology embodiment comprises two or more bus drivers being connected to the powered audio bus at different locations, e.g. four bus drivers being distributed along the powered audio bus, and mutually coordinating or being coordinated which one operates as active bus driver during normal operation. In case of bus failure, a re-coordination takes place to determine the most appropriate bus drivers to take over operation of any amputated parts of the bus, and each active bus driver performs a re-enumeration of connected nodes.

Various other topology embodiments, including for example combinations of the topologies described and shown with reference to figures 4 - 6 are possible and suitable for different applications, building layouts, purposes, safety regulations, etc.

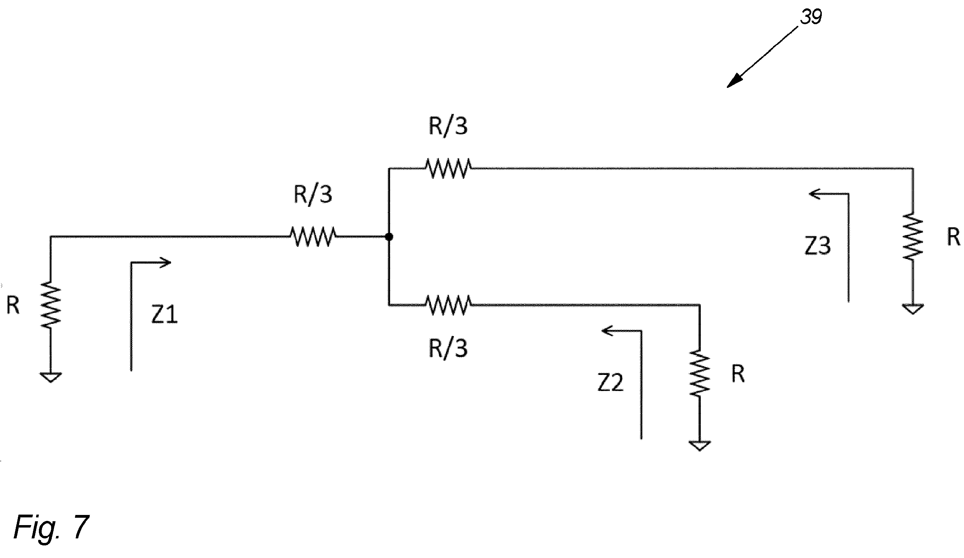

Impedance matching in a Y-splitter 39, as for example suitable for a branched powered audio bus as shown figure 5, can be established using three identical impedances, also called a "hairball network" as illustrated in figure 7 (single ended for the sake of simplicity). Seen for any end of this star configuration, the impedances Z1, Z2 and Z3 equals $R/3 + (R/3+R)/2 = R$, which ensures that reflection related problems are minimized. However, the network introduces an attenuation of 6dB from one branch end to another.

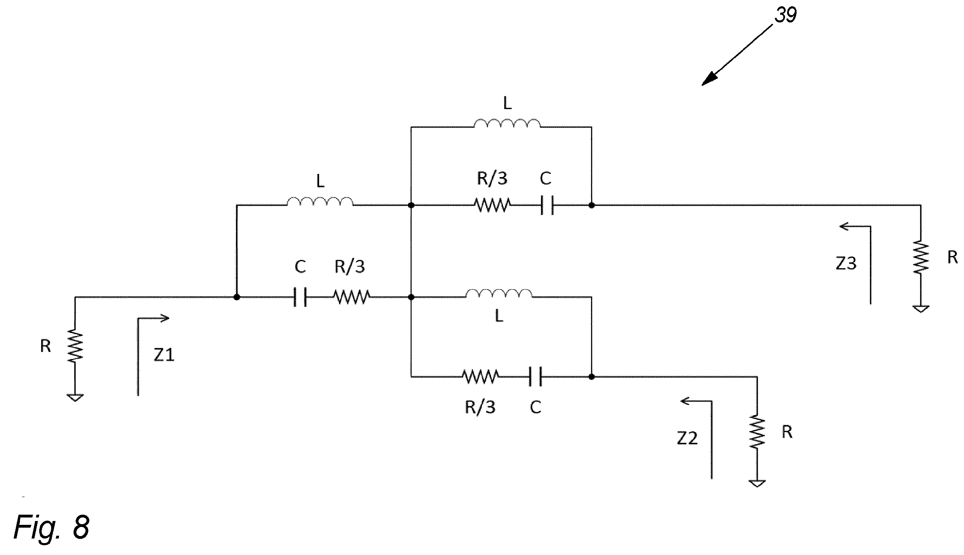

For a 2-line DC powered bus, the pure resistor based approach is not suitable, since the relatively small resistors will introduce a significant power loss when drawing current through the bus. To circumvent that problem, the impedance matching means may be designed so that impedance matching resistors only "exist" for AC, leaving out DC. One solution is illustrated in figure 8, where resistors are DC decoupled using capacitors and the DC power distribution is handled through the inductors L.

Figure 9 illustrates a layout of the audio system 33 according to an embodiment of the invention. A first bus driver 1a controls nodes 20a-20d on a first powered audio bus 5a and a second bus driver 1b controls nodes 20e-20h on a second powered audio bus 5b.

The nodes 20a-20h may be located in one or more environments. An environment may for example be defined by a room. A zone including a subset of nodes 20 may be defined more or less related to environments and bus, and provides an abstraction level for assigning any loudspeaker to zones regardless of their environment and bus topology. Typically, assignment to zones is used to broadcast the same audio or controls to the nodes of a common zone. It should be mentioned that the grouping of subsets of nodes 20 in zones or environment may include nodes 20 controlled by different bus drivers 1. Hence a zone or subset of nodes 20 should be understood as one or more nodes 20 grouped and thereby playing the same audio signal.

Figure 9 illustrates two daisy chains of nodes 20a-20d and 20e-20h distributed over two environments, rooms 37 and 38. The first room 37 may be divided in two zones 37a and 37b e.g. based on use of the room 37, hence zone 37a may be a busy and noisy area and zone 37b is a relaxing area of room 37. Room 38 represents only one zone denoted 38a.

Now if different audio signals are to be broadcasted in environments 37 and 38, the nodes 20a-20h have to be divided in zones. Hence zone 1 comprising node 20a-20c and 20h, zone 2 comprising nodes 20d and 20e and zone 3 comprising nodes 20f and 20g.

The subset of nodes representing zones 1-3 is either automatically or manually configured to the respective zones facilitating the playing of different audio or the same audio at different sound levels. Playing an audio signal should be understood as converting an audio signal to speech, music, tones, etc. audible at least to humans.

In an embodiment, the nodes may be pre-configured during installation, for example with regard to zone assignment, audio channel selection, audio level, or other basic configuration parameters. The pre-configuration of a node may for example be facilitated by the nodes comprising a hardware selector and/or a programmable memory, which the installer may use to set one or more parameters, and which may be read by internal circuitry after power-on. For example, a rotary encoder, a DIP-switch (DIP: dual inline package), an NFC-receiver (NFC: near field communication), an RFID-tag (RFID: radio frequency identification), etc., may be provided at the node. During installation, there is access to the pre-configuration selector at the node, and the installer may pre-configure for example which zone the node initially belongs to, and an initial attenuation level. The pre-configuration may even be applied before the node is connected to the powered audio bus, and thereby before it receives any power. The settings may be part of an installation project plan or be decided spontaneously by the installer. However, as such pre-configuration is prone to human error and/or change of mind after closing off the installation, ceiling, wall, etc., an embodiment comprising a verification of the pre-configuration is therefore very advantageous, as is a preferred embodiment allowing the bus driver to overrule the pre-configuration of a node.

To facilitate the automatic configuration of zones, the bus drivers 1a and 1b may be connected either directly or via an external audio source 8 or external controller 10.

Accordingly an aggregated environment comprises a set of environments 37, 38 each comprising one or more of the loudspeakers (also referred to as nodes) of the loudspeaker system. Each environment comprises a physical area e.g. a hallway, a conference room, a restaurant or a similar physically delimited environment. In other words, the environments are defined by physical structures serving as acoustical and/or visual obstacles such as walls, floors and ceilings, doors and windows, partitions, plants, curtains, or even relatively large distances of space. The aggregated environment may thereby for example be an office building, restaurant building, etc., comprising a set of environments. The aggregated environment is limited to the aggregation of environments comprising loudspeakers of the loudspeaker system, and may thus be limited to a part of a building, floor, etc., and comprise a single environment or several environments. The loudspeaker system may comprise loudspeakers installed in one or more environments.

The topology of the loudspeaker system (also referred to as daisy chained nodes or audio system) in terms of electrical or communicative connections may often be quite unrelated to the topology of the environments.

In an embodiment, sound measurements may be analyzed for information about acoustic obstacles obtained by analyzing when certain microphones do not hear or only vaguely hear the sound from certain loudspeakers, thereby enabling a grouping of the loudspeakers in different of said environments, as well as information about reflective surfaces enabling estimating distances between loudspeakers and surfaces, thereby making it possible in certain embodiments to estimate the dimensions in two or three dimensions of the environments, e.g. the dimensions and shape of a room. In an embodiment, visual information e.g. from a camera, information about physical properties from distance measurements, e.g. by laser or accelerometer, positioning systems or blue prints or other formal data or manually inserted data, etc., may be analyzed to estimate the dimensions of environments and relative or absolute positions of the loudspeakers. In an advantageous embodiment, automatically or manually determined information about environments may be used to make a basic suggestion or basic starting configuration for how the loudspeakers could be divided into loudspeaker zones for the subsequent normal operation. In many practical applications, the basic starting configuration established this way will be perfectly suited for most uses.

The topology of the environments may not necessarily correspond to the topology of the loudspeaker zones. In other words, network-topology, loudspeaker connections, environments and loudspeaker zones are non-constrained, but at least partly overlapping.

In an advanced embodiment, the assigned loudspeaker zones may not be static or permanent, but may be changed according to the application of the room or hall. Applications such as "live concert", "conference", or "lounge bar" may require the loudspeakers to fulfill different roles.

As can be seen from the above description, the inventive audio system 33 has several advantages of which the feature of power and bidirectional data transmitted over a two wired powered audio bus 5 between the bus driver 1 and the nodes 20 and the polarity-indifference of the two wires 34a, 34b are especially advantageous.

Of these advantages could at least be mentioned individual fault monitoring of loudspeaker 32, individual gain, delay and equalizing with high granularity, dynamic paging and grouping of nodes 20, multiple node types on the same daisy chain, more than one zone or channel on the same daisy chain, possibility of retrofitting or updating existing audio systems without need of installing new transmission line between nodes of the existing system, equal audio quality in first and last node 20 of the network, facilitates automatically debugging locating at which node an error may be present and use of thinner conductors 34 compared to traditional comparable audio systems.

The reason for being able to use thinner conductors 34 at the present audio system 33 compared to e.g. 70VRMS is that at 70VRMS, the RMS of the audio signal is significantly lower than at the 40V - 50V DC system suggested by the present invention. Hence the currents and thereby losses of the present audio system 33 are reduced significantly as compared to a 70VRMS system.

Compared to the traditional 70/100V installation technology, at least the following advantages exist:

- Cabling may be phase indifferent. Swapped conductors in the cable will not cause 180 degree phase change for the resulting acoustical output.
- More than one audio channel may be transported on a single cable (twisted pair) simultaneously. This means that multiple zones can be covered using a single daisy chain (cable).

- The system may incorporate a node enumeration process that establishes a list holding all bus nodes including the physical (electrical connection) sequence from first to last node on the bus. This list ensures that all electrical connections are functioning. Deviations from the list obtained during last power-up, may be reported (automatically via email or similar) to a given location.
- The system may incorporate a self-test feature, which tells the installer/maintenance personnel where the last functional node on the cable is located.
- Each node may implement individual level control, EQ and other DSP related functions which can be remotely controlled. This is an advantage when the system is installed in an environment where it would be advantageous to shift "sound profile" as function of the environment, e.g. in a restaurant, where it would be desirable to adjust sound level in only a sub-section of the total restaurant space for some occasions - or even differentiated audio material (corresponding to dynamic/virtual routing capability).
- The status of each individual node can be monitored, meaning that loudspeaker (and amplifier) status (temperature, power consumption, impedance) can be continuously followed.
- The sonic quality may be improved, due to the absence of the audio power transformer, which typically requires that the audio signal is high-pass filtered to avoid distortion for low frequencies. Driving the loudspeaker directly without this transformer will enable a richer and more tight bass reproduction.
- The power loss in the cabling will be lower compared to a 70/100V system when reproducing audio material. For typical audio signals, the crest factor is 12dB. This means that the RMS voltage for full scale audio in a 70V (100V peak) system is only 25V, compared to the proposed system, maybe having 48VDC (=48Vrms) on the bus. This difference will cause a current in the 70V system, that are roughly twice the current in the 48V system, turning into four times higher cable power loss ($P = I^2 \cdot R$), assuming similar cable thickness (resistive conduction loss). This fact may be utilized into either (1) using thinner cables, or (2) offer increased cable length for a given cable dimension (and acceptable loss).
- The system may further comprise several other types of sensors not directly related to the audio reproduction. Examples may be light sensors, smoke sensors, gas sensors (CO), proximity sensors or any other kind of sensor. Information from these sensors may be relayed back to the bus driver 1 and further onto the internet and/or other equipment connected to the driver and/or bus.
- The bus peak voltage is lower compared to 70V (100V peak) or 100V (140V peak). Using 48V means that the system may be mounted by "anybody", since 48V is considered non-hazardous, whereas the installation of 70/100V systems may require certified personnel.

The description of the figures has focused on the elements providing a feature to the invention. Therefore it should be mentioned that other not mentioned elements may also be implemented in various embodiments. Such elements could be capacitors mounted between the transmission conductors 34 of the powered audio bus 5 and the driver processing unit 11, the data transmitter and receiver of the bus driver 1 and the transmission conductors 34 of the powered audio bus 5 which is used as a filter for preventing the DC power signals from interfering with the processing of the data.

In the same way, an inductor may be present between the power supply 3 of the bus driver 1, the power converter 35 of the node 20 and the transmission conductors 34 of the powered audio bus 5 to filter and ensure that the data communication does not interfere with the power supply.

It should be mentioned that any elements of any of the figures referred to in this description may be combined to obtain an audio system 33 complying with specific requirements. Further, many elements of the figures are state of the art elements and are therefore not described in details in that they and their functions are known by the skilled person.

The audio system 33 is also referred to as a loud-speaker system 33, driver power supply 2 is also referred to as a bus power supply 2, a node digital receiver 28 is also referred to as a node receiver 28, a node power amplifier 31 is also referred to as an amplifier 31, a node power supply 35 is also referred to as power converter 35 arranged to convert power from the powered audio bus to supply power to at least partly the node processing unit and the node receiver,

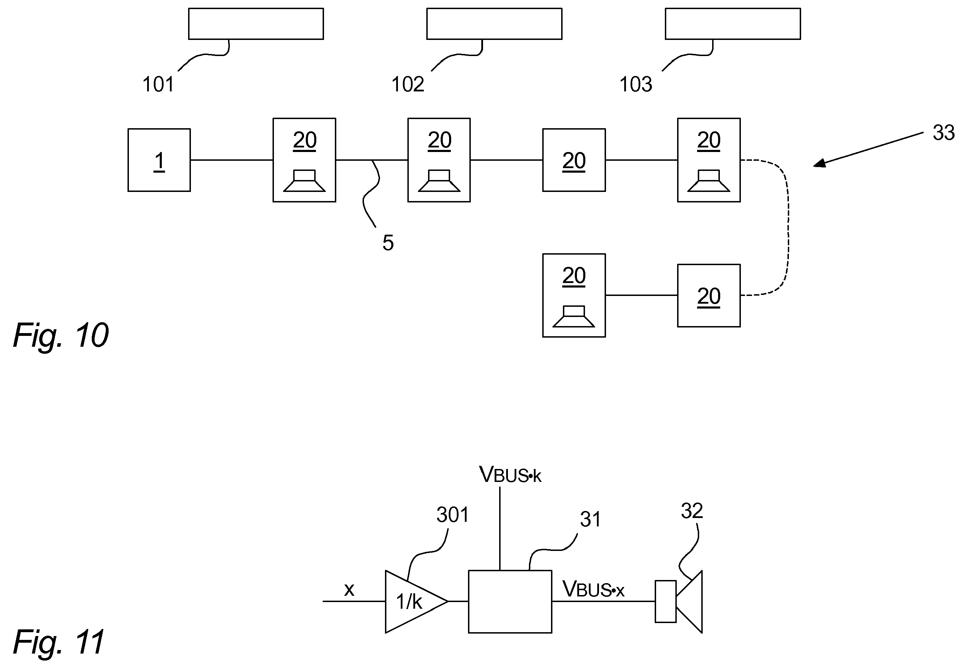

Figure 10 illustrates the loudspeaker system 33 configured with a monitoring unit 101 for monitoring a power consumption impacting parameter, a testing unit 102, for determining when a criterion for power consumption control is fulfilled, a power consumption control arrangement 103 for reducing power consumption of one or more of the loudspeaker nodes on the basis of the criterion being fulfilled.

**Amplifier losses, switching losses, gain compensation**

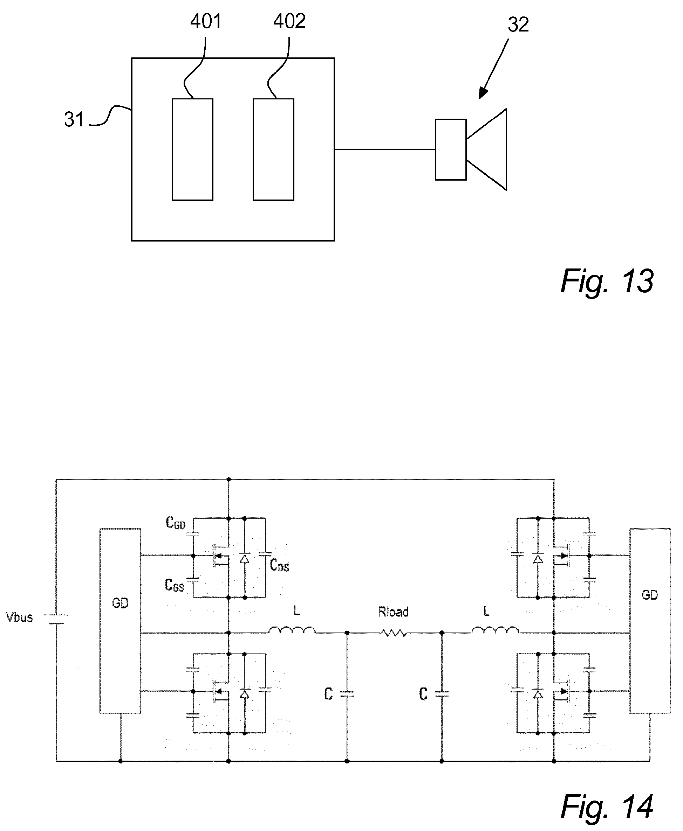

Figure 14 shows a diagram of a typical single supply, full-bridge Class-D power stage. Two half-bridges, supplied with Vbus, drives a load (Rload) through L-C filters. The power inductors (L) are coupled to the switch node on one side and on a load terminal on the other. The MOSFETs are illustrated with their inherent body-diodes and parasitic capacitances Cgd, Cgs and Cds. The resulting capacitance of the switching node (Coss) is a function of these capacitances. The MOSFETs are driven by gatedrivers (GD).

Power loses in a single-supply class-D amplifier using four identical MOSFETs configured in a full-bridge may be described by the equations:

$$P_{tot} = P_{sw} + P_{cond} + P_{gd}$$

$$P_{sw} = C_{oss} \cdot V_{bus}{}^2 \cdot F_{pwm} + 2 \cdot I_d \cdot V_{bus} \cdot T_t \cdot F_{pwm}$$

$$P_{cond} = 2 \cdot \frac{R_{dson}}{R_{load}} \cdot P_{load}$$

$$P_{gd} = 2 \cdot Q_g \cdot V_{gs} \cdot F_{pwm}$$

where Psw is a loss due to switching the parasitic capacitance in the switching transistors, Pcond is the conduction loss related to the MOSFET on-resistance, Pgd is a gate drive loss primarily caused by the miller capacitance, Rdson is the MOSFET on-resistance , Rload is load resistance, Pload is the power dissipated in the load, Qg is the gate charge required for changing state of the halfbridge, Vgs is the gate-source voltage required for turning on the MOSFET, Fpwm is the switching frequency, Coss is a parasitic capacity found at the halfbridge switching nodes, Vbus is the voltage delivered by the bus driver 1 to the loudspeaker nodes 20 and amplifiers of the nodes, Id is the MOSFET current at the transition beginning (which in idle operation corresponds to the peak inductor ripple current), and Tt is the transition durationn.

The first term in P_sw is referred to as P1 and the second term is referred to as P2.

The switching loss Psw is proportional to the squared bus voltage Vbus (Id - which corresponds to the peak ripple current in the class-D L-C demodulation filter - is proportional to Vbus, which also makes P2 proportional to the squared bus voltage) and also proportional to the switching frequency Fpwm.

According to an example where Vbus = 50V, Coss = 1nF, Vbus = 50V, Fpwm = 400kHz, Id (LC filter ripple current) = 1A, and tf = 10ns, the switching loss is Psw = P1 + P2 = 1W + 0.4W = 1.4W.

By reducing Vbus to 25V (and Id thus to 0.5A), the switching loss is reduced to Psw = P1 + P2 = 0.25W + 0.1W = 0.35W.

Accordingly, significant power savings can be achieved by reducing the bus voltage Vbus, by reducing the switching frequency Fpwm or by bringing the amplifier into a sleeping mode, e.g. by reducing the bus voltage to zero or disconnecting the amplifier and/or switching transistors from the bus voltage.

**Reducing power consumption by setting nodes to standby**

The power consumption control arrangement 103 may be arranged to set one or more loudspeaker nodes 20 to a standby mode. The standby mode may include any mode where the node is set to consume an amount of power which is lower than normal power consumption when the node is not in a standby mode, i.e. lower than a fully functioning mode, e.g. a mode when the node is in a normal or default mode for rendering the audio information, e.g. encoded audio information. For example, the loudspeaker node 20 may be configured to switch off processing unit 23, the amplifier 31 or other units of the node 20. By switching off the amplifier 31 idle-time losses in the amplifier and loudspeaker are avoided. Switching off a unit may be achieved by suppressing supply of power to the unit, e.g. by means of a switch, or by tri-stating the switching transistors (MOSFETs) of the amplifier 31, or by keeping the half-bridges in the same state thus avoiding current to flow in the connected load. In general, setting the node 20 to a standby mode may involve switching some or all of the functions, subcomponents and unit.

The setting of the node to a standby mode may be achieved by instructions received from the bus driver 1 via the powered audio bus 5, or received from other external components or sensors.

The loudspeaker node 20 may be configured to keep certain units, functions or subcomponents, e.g. at least the node receiver 28, on in order to enable recognition of any instructions from the bus driver or other external component or sensor to wake up from the standby mode.

The loudspeaker node 20 may be configured to be set different standby modes characterized by different degrees of being shut down, for example different numbers of subcomponents switched off or different functions being disabled. Accordingly, the power consumption control arrangement 103 may be arranged to set two or more loudspeaker nodes 20 to different standby modes.

In addition to setting a standby mode, the power consumption control arrangement 103 may also be arranged to set a node 20 to the default mode, i.e. the fully functioning mode, e.g. via wake-up instructions sent via the powered audio bus 5. In other words, the power consumption control arrangement 103 is in control of the individual loudspeaker nodes 20 entering or leaving standby modes.

The power consumption control arrangement 103 may be comprised by the bus driver 1. Accordingly, the bus driver may be arranged to set a loudspeaker node to a particular standby mode or default mode, e.g. by sending instructions via the powered audio bus 5.

Additionally or alternatively, the power consumption control arrangement 103 may be comprised a loudspeaker node 20. For example, a power consumption control arrangement 103 comprised by one node 20 may autonomously set this node into a standby mode. According to an embodiment, the power consumption control arrangement 103 comprised by one node 20 may additionally be configured to set other nodes 20 into a standby mode via instructions sent by the node transmitter 30. Thus, one or more of the loudspeaker nodes 20 may comprises a node transmitter 30 arranged to transmit communication on the powered audio bus 5. Accordingly, one or more of the loudspeaker nodes 20 may be arranged to control to set itself and/or other nodes 20 into a standby mode.

The autonomously decision to enter a standby mode of the node itself and/or other nodes may be performed by a testing unit 102 comprised by the node.

The autonomously decision to enter a standby mode may require an authorisation, e.g. an authorisation provided via instructions from the bus driver 1. Accordingly, a node 20 may be arranged to be authorised to enable setting itself and/or other nodes into a standby mode.

The standby mode of the power consumption control arrangement 103 being comprised a loudspeaker node 20 may comprise keeping the node receiver 28 on in order to receive instructions for leaving the standby mode or changing the standby mode, or in order to be able to detect when an audio signal for the respective node 20 is present on the powered audio bus 5.

In general, one or more of the monitoring unit 101, the testing unit 102 and the power consumption control arrangement 103 may be comprised by the bus driver 1, one or more of the loudspeaker nodes 20 or other units. Alternatively, one or more of the monitoring unit 101, the testing unit 102 and the power consumption control arrangement 103 may be comprised by an external unit capable of communicating with the bus driver 1 or the one or more loudspeaker nodes 20.

The monitoring unit 101 is arranged for monitoring a power consumption impacting parameter. The consumption impacting parameter may comprise the audio information, control information, a human absence indication or other information.

The audio information monitored by the monitoring unit 101 may be utilised, e.g. by the testing unit 102, for determining criteria for deciding to reduce power consumption in certain loudspeaker nodes. Different criteria which can be determined from the audio information comprise non-presence of the audio signal and volume of the audio signal below a threshold.

For example, if no audio signal is present on the powered audio bus 5, the power consumption control arrangement 103 may instruct one or more loudspeaker nodes to enter a standby mode. For example, the bus driver may instruct loudspeaker nodes to enter the standby mode, or the individual loudspeaker nodes may decide to enter standby mode if the individual nodes does not receive an audio signal to be rendered.

The control information monitored by the monitoring unit 101 may be utilised, e.g. by the testing unit 102, for determining criteria for deciding to reduce power consumption in certain loudspeaker nodes. Different criteria which can be determined from the control information comprise instructions for a certain loudspeaker node to not process the current audio signal present on the powered audio bus, e.g. instructions such as the node being assigned to a different audio channel, the node being muted and the node being deactivated.

For example, the power consumption control arrangement 103 may instruct one or more loudspeaker nodes to enter a standby mode dependent on the control information. For example, the bus driver 1 may analyse the control information and instruct the relevant loudspeaker nodes to enter standby mode, or the individual loudspeaker nodes may analyse the control information and decide when to enter standby mode individually.

The power consumption control arrangement 103, e.g. bus driver 1 or a loudspeaker node 20 may decide to set one or more loudspeaker nodes 20 to a standby mode on the basis of control information even though said one or more loudspeaker nodes 20 receives an audio signal, e.g. an audio signal intended to be rendered by other loudspeaker nodes 20.

In the aforementioned example where the power consumption impacting parameter comprises a human absence indication, the criterion for power consumption control, i.e. for reducing power consumption, comprises human absence within an acoustic proximity of a loudspeaker node 20. For example, if no human is present within a certain distance, i.e. within the acoustic proximity, from a loudspeaker node 20, that node and possible nearby nodes may be set to standby.

The human absence indication, or a human absence signal, may be generated by human absence indicator, e.g. a proximity sensor or movement sensor, e.g. a passive infrared sensor (PIR-sensor), or noise sensor, e.g. a microphone. The human absence indicator may be connected to the loudspeaker system, for example directly to the bus driver 1 or to one or more loudspeaker nodes 20, for determining when human absence is indicated and on that basis let respective loudspeaker nodes enter a standby mode.

The human absence indicator may also be derived from information obtained from light switches or light sensors in a room, from a time schedule indicating that an environment will be vacated during certain periods.

The power consumption control arrangement 103 may be arranged to set loudspeaker nodes 20 outside acoustic proximity of any listener to a standby mode. That is, when the sound produced by a loudspeaker node due to distance or obstacles such as walls may be considered insignificant to any listener such loudspeaker nodes may be muted. Thereby loudspeaker nodes in an empty room may enter standby mode as probably being insignificant for anyone outside the room. Additionally, one or more loudspeaker nodes in a large environment, e.g. a large hall may be set to a standby mode if they are sufficiently far from any listeners, possibly conditioned by the requirement that other loudspeaker nodes are located closer to the listeners. The human absence indication may analysed, e.g. to determine if a criterion, e.g. distance, is fulfilled by the testing unit 102, by the bus driver 1 or one or more individual loudspeaker nodes 20. In an embodiment, one or more loudspeaker nodes 20 comprises a sensor or other input device to receive human absence information, e.g. light sensor, proximity sensor or noise sensor, and forwards the information raw or analysed to the bus driver, which may then make a decision about the relevance of entering a standby mode and instruct any relevant loudspeaker nodes, including the one equipped with the sensor, accordingly.

Entering or leaving a standby mode for a loudspeaker node may cause undesirable noise such as pop or click sounds. It is therefore beneficial to provide the loudspeaker nodes with an arrangement such as a pop or click reduction arrangement for avoiding this effect. In various embodiments where the amplifier comprised by the loudspeaker node is a class-D amplifier, the pop or click reduction arrangement may be implemented in the pulse modulator of the amplifier. For example, the pop or click reduction arrangement may control the pulse modulator, when turning on or starting after standby, to establish as the first pulse a deliberately narrower pulse than the regular pulses based on the audio signal. The pop or click reduction arrangement may control the pulse modulator, when entering standby or being turned off, to first fade the audio out, and then establish a deliberately narrow pulse after the last of the regular pulses has occurred.

**Reducing power consumption by reducing bus voltage**

The power consumption control arrangement 103 may be arranged to reduce the bus voltage V_BUS generated by the bus power supply. As explained, reducing the bus voltage reduces the switching losses P_sw.

A relatively high voltage is typically desired on the powered audio bus 5 in order to supply a relatively high power to the loudspeaker nodes 20 without losing too much power due to conduction losses in the power cables and without requiring power cables with a very low resistance (i.e. thick cables).

The relatively high voltage may also be desirable in order to achieve a sufficiently high sound energy with a given amplifier design, e.g. because of limitations due to conduction losses.

At a lower bus voltage, besides the increasing conduction loss, the amplifier and loudspeaker may not be able to produce their rated sound pressure, and as mentioned above, the conduction loss may become significant and unacceptable at high currents, which is emphasized by lowering the voltage.

Since the powered audio bus may comprise several, possibly different, loudspeaker nodes playing different audio at different settings it is a non-trivial task to determine when the loudspeaker system as a whole may benefit from a reduced bus voltage and still satisfy a sufficient audio performance.

The monitoring unit 101 used for monitoring impacting parameters for the purpose of invoking a standby mode may additionally or alternatively be used for monitoring similar or other parameters for the purpose of invoking a reduced bus voltage mode where the bus voltage is reduced.

For example, the monitoring unit 101 may monitor the audio information and/or the bus voltage V_BUS as parameters of the impacting parameter. Based on the audio information it can be determined if the sound to be produced by one or more loudspeaker nodes is sufficiently below the full capacity of the nodes, e.g. below a given sound pressure level threshold. Optionally, the bus voltage may be monitored or determined from a setpoint data comprised by the bus driver 1 in order to determine if the actual bus voltage is high enough, e.g. equal to the nominal bus voltage (e.g. 48 V), to enable a significant reduction in the switching loss P_sw.

If the audio information satisfies a given criterion for power consumption control, e.g. a criterion defining that the audio information sets a sound pressure level to be rendered which is below a threshold, and optionally dependent on a criterion defining that the bus voltage is sufficiently high, e.g. above a threshold, the power consumption control may be invoked, i.e. a reduction of the bus voltage V_BUS may be invoked.

Various loudspeaker nodes may be set to apply different audio processing such as for example gain, compression and equalization to the audio signal. Such further parameters, which may be monitored as impacting parameters, may additionally be used for defining further criteria to be fulfilled for invoking the power consumption control, i.e. bus voltage reduction, using the power consumption control arrangement 103.

Since it may be determined that the sound pressure level to be rendered, as defined by the audio information, may not require the actual bus voltage, i.e. the sound pressure level may be obtained by a lower bus voltage V_BUS, a criterion for power consumption control may be defined as the criterion defining that the bus voltage is higher than required by one or more loudspeaker nodes 20.

The bus voltage may be reduced to a bus voltage in the range of 10% to 99%, preferably in the range from 10% to 80% of the nominal voltage of the powered audio bus. The actual voltage reduction may be dependent on a minimum bus voltage being sufficient for overcoming an allowable voltage drop in the powered audio bus 5 and/or sufficient for driving the electronics of the loudspeaker nodes.

For example, a nominal bus voltage of 48 V may be reducible to at least 25%, i.e. to 12 VDC to still drive for example 16 loudspeaker nodes over 100 meters of cable as long as none of them are required to play with a sound pressure level above a given threshold. A 25% voltage reduction causes the switching loss in the amplifiers to fall to about 1/16 of the nominal switch loss.

The power consumption control arrangement 103 may be configured to cause a change of the bus voltage V_BUS. Accordingly, the bus driver 1, one or more of the loud-speaker nodes 20 or a power consumption control arrangement 103 located elsewhere may determine the voltage reduction or voltage reduction instructions (intended for the bus driver 1). The voltage reduction determined by the bus driver 1 or voltage reduction/voltage reduction instructions received by the bus driver causes the power supply of the bus driver to modify the bus voltage accordingly.

The amplifier of the loudspeaker node 20 may be a switching amplifier arranged with a feedback loop, e.g. a class-D closed loop amplifier, to counteract bus voltage reductions with respect to a sound pressure rendered by the loudspeaker nodes.

In an embodiment, the amplifier is a closed-loop class-D amplifier, which may thereby compensate for the bus voltage reduction and together with the loudspeaker deliver the intended sound pressure level, provided that the audio signal received at the loudspeaker node comprises only low amplitude levels leaving room for the compensation within the dynamic range of the amplifier. The compensation in the closed loop amplifier may effectively cause an increased gain in the closed-loop amplifier.

Alternatively, the amplifier of the load speaker node 20 may be a switching amplifier arranged to apply a gain to the audio information or control information to counteract the bus voltage reduction with respect to a sound pressure level rendered by the loudspeaker nodes. Such a switching amplifier may be an open-loop amplifier, e.g. an open-loop class D amplifier.

When the amplifier is an open-loop amplifier, either the amplifier or the bus driver is arranged to apply a gain to the audio signal proportional to the reduction of bus voltage in order to be able to deliver the intended sound pressure level from the loudspeaker nodes. This ensures an overall unchanged gain from the audio signal to the loudspeaker voltage signal, regardless of bus voltage.

Figure 11 illustrates an open-loop amplifier 31 powered by the bus voltage V_BUS x k, where k is a voltage reduction factor between zero and one. The audio signal, here illustratively exemplified by the signal x, is multiplied with the reciprocal of k in order to adaptively modify the nominal gain. Here a nominal gain of the gain unit 301 is assumed to be one. The voltage of the output of the amplifier 31 is given as the product of the supply voltage and the audio signal:

$$(V\_BUS \cdot k) \cdot (x/k) = V\_BUS \cdot x.$$ Accordingly, the output voltage of the amplifier and, thereby, the sound pressure level, is at least partly independent of variations of the bus voltage V_BUS.

The modified gain or gain modification 1/k may be determined individually by single loud-speaker nodes 20, e.g. by a processor of the nodes dependent on the monitored bus voltage supplied to the single node. Accordingly, voltage droops due to cable resistance in addition to the voltage reduction performed by the power supply of the driver 1 is compensated individually by the nodes. Accordingly, different nodes 20 may have different modified gain values, e.g. dependent on cable resistance between the driver 1 and the nodes 20.

Alternatively, the modified gain may be determined by the bus driver 1. In this case a single modified gain value common for one or more nodes 20 may be determined. However, two or more modified gain values could also be determined by the bus driver 1, e.g. dependent on predetermined, measured or estimated cable resistance, and transmitted to two or more nodes 20.

The modified gain determined by the bus driver may be comprised by the audio information or by the control information transmitted to the loudspeaker nodes 20. The audio information may be included in the audio information by the bus driver 1 or by the loudspeaker nodes 20.

In case that the loudspeaker nodes make use of individual audio processing or parameters, each loud-speaker node 20 may be configured to determine a required bus voltage or minimum acceptable bus voltage and to communicated this voltage information, e.g. in the form of bus voltage instructions, to the bus driver 1, testing unit 102 or power consumption control arrangement 103. The bus driver or other unit may be configured to determine a common minimum acceptable bus voltage based on the received voltage information from the nodes and to instruct the power supply to generate this voltage.

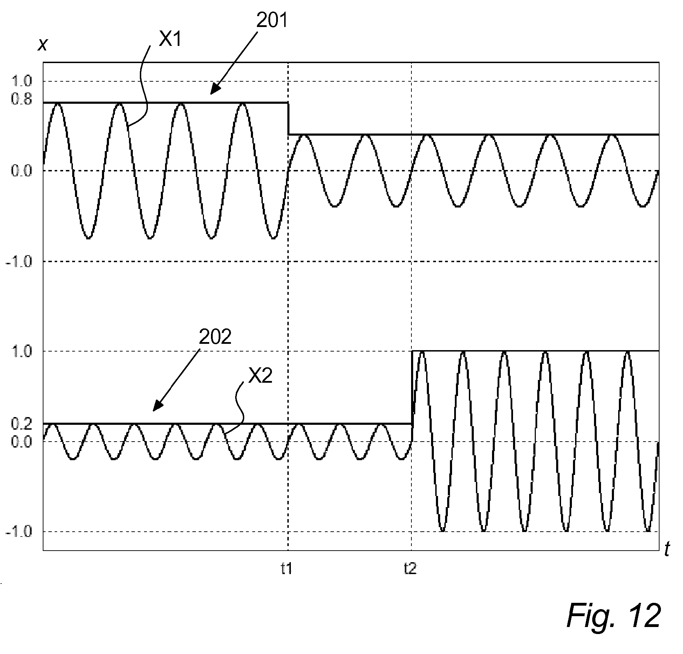

Figure 12 schematically illustrates an example where the audio information comprises first and second audio signals x1 and x2 intended for respective first and second groups of loud-speaker nodes distributed along one or more powered audio busses 5 powered by the same bus driver 1. The normalized amplitude of the audio signals is defined to be between -1 and 1. The curves 201 and 202 illustrates a determined sound pressure level (normalized between -1 and 1) to be rendered, as defined by the audio information x1, x2.

The one or more powered audio buses may have integrated or network-connected bus drivers. Accordingly, one or more bus drivers may be integrated in a single integral bus driver, where the integral bus driver may support powering of and transmission of audio and control information to one or more powered audio busses. Alternatively, one or more individual bus drivers may be network-connected, e.g. via a LAN bus, and commonly controlled by a central controller connected to the individual bus drivers. A central controller may also be provided for controlling the one or more integrated bus drivers.

Due to the presence of different audio signals x1, x2, the maximum audio level 201, 202 varies over time. Accordingly, the power consumption control arrangement may be arranged to reduce the bus voltage dependent on the greatest audio level of a plurality of audio levels 201, 202, where the greatest audio level is determined over time, continuously or at fixed time points.

Thus, up to time t1 and further up to time t2, audio level 201 has the largest audio level, whereas audio level 202 has the largest audio level after time t2. At any time or at predetermined time points the voltage reduction is determined from the audio levels 201,202.

It is noted that, look-ahead delay, smoothing filters, and timing mechanisms like attack/hold/release may be used to ensure that the gain compensation is substantially inverse proportional to the bus voltage at all times.

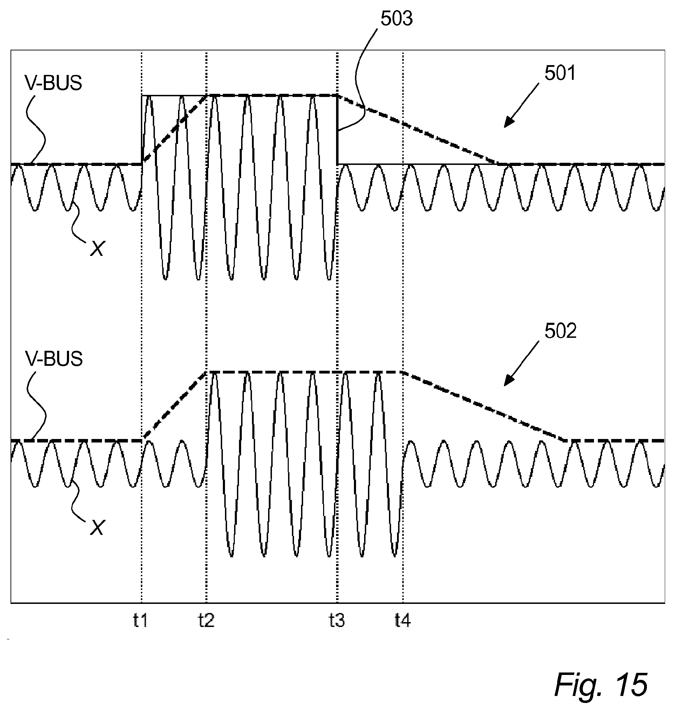

Figure 15 explains the effect of the look-ahead delay. The upper and lower illustrations 501, 502 contain curves for the bus voltage V_BUS, the audio signal x and an envelope 503 corresponding to the sound pressure level of the audio signal.

The upper illustration 501 shows that the amplitude of the audio signal suddenly increases at t1. Ideally, the bus voltage V_BUS should also increase instantly in order to allow the loudspeaker nodes to render the audio signal x correctly or without too much distortion. However, due to capacitances of the loudspeaker nodes and due to limited power or current capabilities of the power supply of the bus driver 1, the charging power of the power supply is limited so that the bus voltage V_BUS cannot increase instantly, but increases gradually between t1 and t2. Accordingly, between t1 and t2 the bus voltage is not sufficiently high to enable the nodes to render the audio signal correctly.

At time t3 the amplitude of the audio signal x suddenly decreases again and, therefore, the bus voltage could ideally also have been decreased instantly. However, due to the charged capacitances, the bus voltage is only able to decrease slowly after t3.

During the gradual increase and decrease in the time intervals t1-t2 and t3-t4, the gain or gain compensation 1/k should ideally be changed dependent on the changing bus voltage. However, since it is difficult to predict the changes of the bus voltage, the variations of the gain or gain compensation 1/k cannot be determined correctly. A possible solution to this may be the control the increase and the decrease of the bus voltage, e.g. by slowing down the rate of changes of the voltage increase or decrease, e.g. by use of predetermined voltage ramping rates.

Another solution to the problem is to implement a look-ahead delay as shown in the lower illustration 502 where the audio signal is delayed. This may be achieved by configuring the bus driver to insert a delay of the audio information before the audio information is transmitted via the bus to the nodes. Illustration 502 shows that the signal x is delayed by the look-ahead delay time t2-t1. The look-ahead delay time must be large enough to ensure the bus voltage has sufficient time to increase from a minimum voltage to the nominal bus voltage. By use of the look-ahead delay it is achieved that the bus voltage has reached the high level before the jump in the audio signal arrives at the nodes. Similarly, the high level of the bus voltage must extended by the amount t2-t1, i.e. from t3 to t4 since the delayed audio signal from t3 to t4 requires the high bus voltage.

As described above, the bus driver 1 may determine the voltage reduction or voltage reduction instructions. Additionally, the bus driver 1 (or power consumption control arrangement 103 in general), may determine a time of the voltage reduction, e.g. when and/or for how long time the bus voltage should be reduced.

Due to a delay between the time when audio information is available at the bus driver (e.g. when audio is received or generated by the bus driver) and the time when the audio information is available at a given loudspeaker node 20, the bus driver (or testing unit 102 or power consumption control arrangement 103) is able to determine if an increased bus voltage is required or if reduced bus voltage is feasible.

The delay may be caused by processing time, e.g. audio processing of the audio information, or may be an intentionally implemented delay, e.g. an implemented look-ahead delay is implemented.

The testing unit 102 or power consumption control arrangement 103, e.g. the bus driver 1, may utilize stored information to determine a reduced bus voltage V_BUS. Such stored information may include a look-up table relating reduced bus voltages to information derived from the audio information, e.g. sound pressure levels derived from the audio information.

Since the voltage amplitude of the output of the amplifier 31 is given by (V_BUS · k) · (x/k) = V_BUS · x, the reduction in the bus voltage may in principle be arbitrarily selected as long as the current in the cable of the powered audio bus 5 does not exceed certain limits, e.g. current limits determined from considerations of conduction losses in the cables.

As noted above, due to conduction losses in the cables and, thereby, presence of voltage drops as a function of cable length, the loudspeaker system may advantageously be arranged so that the nodes 1 are capable of determining the modified gain or gain modification 1/k.

Further examples of such stored information includes tolerances to lower bus voltages, available gain levels for different nodes 20, details about equalization, compression and other audio processing implemented in different nodes.

Reducing power by changing amplifier hardware

Figure 13 shows an amplifier 31 configured with at least first and second switching power stages 401, 402. Either the first or the second power stage is used at any time for driving the loudspeaker 32. The loudspeaker node 20 or a power consumption control arrangement 103 is configured to select one of the switching power stages 401, 402, e.g. dependent on a consumption impacting parameter and a criterion for power consumption. For example, the bus voltage V_BUS at the location of a load-speaker node 20 and the audio information or sound pressure levels derived therefrom may be used for determining which of the power stages should be selected.

Accordingly, the power consumption control arrangement 103 may be arranged to couple switching power stages 401, 402 or other subcomponents of the amplifier 31 in or out.

For example, the switching power stages 401, 402 may be configured with field-effect-transistors FET with different drain-source on-resistances RDS(on). A power stage 401, 402 configured with low drain-source on-resistances RDS(on) has low conduction losses any may therefore generate the lowest power losses when the loudspeaker node 20 is required to produce high sound pressure levels. A power stage 401, 402 configured with high drain-source on-resistances RDS(on) normally has low gate losses and, therefore, low switching losses and may therefore generate the lowest power losses when the loudspeaker node 20 is required to produce low sound pressure levels. Consequently, the power stage with low drain-source on-resistances RDS(on) is selected for high sound pressure levels and the power stage with high drain-source on-resistances RDS(on) is selected for low sound pressure levels.

**Reducing power by changing audio processing**

The power consumption due to rendering of audio information in the loudspeaker nodes 20 may be reduced by changing audio processing parameters.

Examples of audio processing parameters comprise reductions of audio level, shaping or restriction of the audio frequency spectrum to a spectrum requiring less energy to reproduce, e.g. shaping which reduces low frequency content of the audio information and switching frequency of the switching transistors of the amplifiers 31.

The power consumption control arrangement 103 may be arranged to change an audio processing parameter dependent on consumption impacting parameters and criteria for power consumption.

For audio processing parameters which are controlled by the bus driver, the bus driver may be configured to change the audio processing parameters, whereas audio processing parameters which are controlled by the loudspeaker nodes the loudspeaker nodes may be configured change the audio processing parameters, autonomously or as instructed by the bus driver via control information.

Changes in the audio processing parameters performed by the bus driver 1 affect all loudspeaker nodes 20 controlled to render the audio information associated with changed audio parameters, whereas changes in the audio processing parameters performed by a given loudspeaker node 20 only affects that node.

Changes in an audio processing parameter in a specific loudspeaker node 20 may be performed dependent on background noise in proximity of the specific loudspeaker node. The local background noise may be measured by the specific node. The audio processing parameter may be changed dependent on the background noise. For example, the audio information may be changed to generate a changed sound pressure level dependent on the background noise, e.g. so that the sound pressure level is reduced for levels of the background noise below a given noise threshold.

Accordingly, the power consumption impacting parameter may include the audio information and/or the background noise level. A criterion for power consumption control may be defined as a change of the background noise level, a certain level of the background noise level or a ratio between the present sound pressure level (determined from the audio information) and the background noise level.

By adjusting the audio level and/or equalization on the basis of the background noise level, the loudspeaker nodes may reduce their power consumption at low background noise while even in many embodiments becoming more comfortable for the listeners, as for example unnecessarily loud announcements or background music is considered uncomfortable for most people.

The power consumption control arrangement 103 may be arranged to change the switching frequency of the switching transistors of the amplifiers 31 in order to reduce power losses. Since the switching losses are proportional to the PWM switch rate, the switching frequency represents an important parameter for achieving power loss reductions.

The PWM process can be looked upon as a sampling process. For a time-continuous pulse width modulation, the audio signal x is "sampled" by a triangular waveform in the modulator. For most audio PWM modulators, the switching frequency is 10-30 times the audio bandwidth, corresponding to 200-600 kHz for full band audio amplifiers (bandwidth = 20 kHz). However, for audio information having reduced bandwidth and/or reduced signal gradients (e.g. reduced signal gradients due to low amplitudes of the signal x), the PWM rate can be reduced while still achieving an acceptable audio quality through the modulation process. Depending on PWM modulation type, the resulting ripple current (switch node output current) may be kept low, even at low switching frequencies. Published patent US 7,728,689 describes a modulator that establishes PWM pulses with short duration, regardless of the PWM switching rate. Consequently, audio content with dominating low frequency content and/or a low signal amplitudes may be suitable for passing through a class-D amplifier having a reduced switching rate compared to its nominal rate.

Accordingly, consumption impacting parameters relevant for determining changes of the switching frequency comprises signal amplitudes and spectral content of the audio information to be rendered by the nodes 3 since low frequency content and/or low amplitude levels may allow for a lower switch frequency.

A criterion (to be processed by the testing unit 102) for determining if the power consumption control arrangement 103 should change the switching frequency may be defined on basis of a comparison of signal amplitudes, signal gradients and/or spectral content with predetermined thresholds relating to signal amplitudes, signal gradients and/or spectral content, where the threshold indicate when a change in the switch frequency is feasible with respect to achieving power loss reductions.

**Claims**

1. A method for controlling power consumption of a loudspeaker system (33), the method comprising

   • providing a powered audio bus (5);
   • providing a bus driver (1) connected to said powered audio bus, the bus driver being arranged to feed control information and audio information into the powered audio bus, the bus driver comprising a driver processing unit (11) and a driver memory;
   • providing a bus power supply (2) connected to the powered audio bus, the bus power supply being arranged to feed power into the powered audio bus; and
   • providing loudspeaker nodes (20) connected to said powered audio bus, each of the loudspeaker nodes comprising

      o a node processing unit (23) and a node memory;
      o a node receiver (28) arranged to receive communication on said powered audio bus;
      o at least one loudspeaker (32) and at least one amplifier (31) arranged to drive said loudspeaker based on power from said powered audio bus and control information and audio information received from said powered audio bus by said node receiver; and
      o a power converter (35) arranged to convert power from said powered audio bus to supply power to at least partly the node processing unit and the node receiver;

   • using a subset of said loudspeaker nodes to produce sound based on said audio information and said control information;
   • monitoring a power consumption impacting parameter;
   • determining on the basis of the monitored power consumption impacting parameter when a criterion for power consumption control is fulfilled; and
   • using a power consumption control arrangement (103) on the basis of said criterion being fulfilled, thereby reducing power consumption of one or more of the loudspeaker nodes.

2. The method according to claim 1, wherein the loudspeaker nodes comprises a node transmitter (30) arranged to transmit communication on said powered audio bus.

3. The method according to any of the preceding claims, wherein the power consumption control arrangement (103) is arranged to set a loudspeaker node to a standby mode.

4. The method according to any of the preceding claims, wherein the criterion for power consumption control comprises a loudspeaker node not receiving audio for rendering, a loudspeaker node being muted or absence within an acoustic proximity of a loudspeaker node.

5. The method according to any of the preceding claims, wherein said power consumption control arrangement is arranged to reduce a bus voltage generated by said bus power supply, preferably to a bus voltage in the range of 10% to 99% of a nominal voltage of the powered audio bus, and wherein the amplifier is a switching amplifier arranged with either a feedback loop to counteract said bus voltage reduction with respect to a sound pressure rendered by the loudspeaker nodes, or arranged to apply a gain (1/k) to the audio information or control information to counteract said bus voltage reduction with respect to a sound pressure rendered by the loudspeaker nodes.

6. The method according to any of the preceding claims, wherein the power consumption impacting parameter comprises said audio information and said bus voltage.

7. The method according to any of the preceding claims, wherein the criterion for power consumption control comprises the bus voltage being higher than required by said loudspeaker nodes.

8. The method according to any of the preceding claims, wherein each loudspeaker node in a subset of the loudspeaker nodes regularly determines a minimum acceptable bus voltage and communicates this to the bus driver for the bus driver to determine a common acceptable bus voltage.

9. The method according to any of the preceding claims, wherein said power consumption control arrangement is arranged to couple subcomponents of one or more of said amplifiers in or out.

10. The method according to any of the preceding claims, wherein said subcomponents comprises different sets of switching power stages (401, 402), said different sets of switching power stages e.g. comprises field-effect-transistors FET with different drain-source on-resistance RDS(on).

11. The method according to any of the preceding claims, wherein said power consumption control arrangement is arranged to change an audio processing parameter, wherein said audio processing parameter is an audio level of one or more of said loudspeaker nodes.

12. The method according to any of the preceding claims, wherein said audio processing parameter is a switch frequency of one or more of said loudspeaker nodes.

13. The method according to any of the preceding claims, wherein the power consumption impacting parameter comprises said audio information or a background noise level.

14. The method according to any of the preceding claims, wherein the criterion for power consumption control comprises a background noise level has changed or that a difference between a sound pressure rendered by the loudspeaker nodes and a background noise level is not within a predefined tolerance of a target level above background noise level.

15. A loudspeaker system (33) with power consumption control, the loudspeaker system comprising:

   • a powered audio bus (5);
   • a bus driver (1) connected to said powered audio bus, the bus driver being arranged to feed control information and audio information into the powered audio bus, the bus driver comprising a driver processing unit (11) and a driver memory;
   • a bus power supply (2) connected to the powered audio bus, the bus power supply being arranged to feed power into the powered audio bus; and
   • loudspeaker nodes (20) connected to said powered audio bus, each of the loudspeaker nodes comprising

      o a node processing unit (23) and a node memory;

    o a node receiver (28) arranged to receive communication on said powered audio bus;

    o at least one loudspeaker (32) and at least one amplifier (31) arranged to drive said loudspeaker based on power from said powered audio bus and control information and audio information received from said powered audio bus by said node receiver; and

    o a power converter (35) arranged to convert power from said powered audio bus to supply power to at least partly the node processing unit and the node receiver;

• a monitoring unit (101) arranged to monitor a power consumption impacting parameter;

• a testing unit (102) arranged to determine when a criterion for power consumption control is fulfilled on the basis of the power consumption impacting parameter; and

• a power consumption control arrangement (103) arranged to reduce a power consumption of one or more of the loudspeaker nodes on the basis of said criterion being fulfilled.

Fig. 1

Fig. 2

EP 3 139 630 A1

*Fig. 3*

Fig. 4

Fig. 5

Fig. 6

*Fig. 7*

EP 3 139 630 A1

Fig. 8

Fig. 9

EP 3 139 630 A1

*Fig. 10*

*Fig. 11*

Fig. 12

401    402

31

32

*Fig. 13*

C_GD
C_GS    C_DS

Vbus    GD

L    Rload    L

C    C

GD

*Fig. 14*

Fig. 15

Europäisches
Patentamt

European
Patent Office

Office européen
des brevets

# EUROPEAN SEARCH REPORT

Application Number

EP 16 18 7211

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 406 634 A (ANDERSON CHARLES W [US] ET AL) 11 April 1995 (1995-04-11) | 1-10, 13-15 | INV. H04R3/12 H04R29/00 |
| Y | * column 3, lines 32-62 *<br>* column 4, lines 58-68 *<br>* column 5, lines 1-50 *<br>* figures 1,2 * | 11,12 | ADD. H04R27/00 |
| Y | US 6 108 426 A (STORTZ JAMES L [US]) 22 August 2000 (2000-08-22) * column 3, lines 12-28 * | 11,12 | |
| A | US 5 818 948 A (GULICK DALE E [US]) 6 October 1998 (1998-10-06) * column 8, lines 8-60 * | 1-15 | |

TECHNICAL FIELDS
SEARCHED (IPC)

H04R

The present search report has been drawn up for all claims

| Place of search | Date of completion of the search | Examiner |
|---|---|---|
| Munich | 16 November 2016 | Rogala, Tomasz |

EPO FORM 1503 03.82 (P04C01)

## ANNEX TO THE EUROPEAN SEARCH REPORT
## ON EUROPEAN PATENT APPLICATION NO.

EP 16 18 7211

This annex lists the patent family members relating to the patent documents cited in the above-mentioned European search report.
The members are as contained in the European Patent Office EDP file on
The European Patent Office is in no way liable for these particulars which are merely given for the purpose of information.

16-11-2016

| Patent document cited in search report | | Publication date | Patent family member(s) | | Publication date |
|---|---|---|---|---|---|
| US 5406634 | A | 11-04-1995 | NONE | | |
| US 6108426 | A | 22-08-2000 | NONE | | |
| US 5818948 | A | 06-10-1998 | DE | 69714460 D1 | 05-09-2002 |
| | | | DE | 69714460 T2 | 03-04-2003 |
| | | | EP | 0941631 A1 | 15-09-1999 |
| | | | US | 5818948 A | 06-10-1998 |
| | | | WO | 9818292 A1 | 30-04-1998 |

EPO FORM P0459

For more details about this annex : see Official Journal of the European Patent Office, No. 12/82

**EP 3 139 630 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7728689 B